# EUROPEAN PATENT APPLICATION

(11) **EP 4 550 012 A1**
(43) Date of publication of application: **07.05.2025**
(21) Application number: 23831049.4
(22) Date of filing: 12.06.2023
(51) Int. Cl.: G02B 1/18, B32B 7/023, B32B 27/00, B32B 27/30, B32B 37/14, C08L 71/02, C23C 14/12, C23C 14/24, G02B 1/115, G02B 1/12, G02C 7/02, G02B 1/14

(54) **METHOD FOR PRODUCING LAMINATE, AND METHOD FOR PRODUCING EYEWEAR LENS**

(30) Priority: 28.06.2022 JP 2022103361
(71) Applicant: Nikon-Essilor Co., Ltd., Tokyo 130-0026 (JP)
(72) Inventor: WAKIYASU Hideyuki, Tokyo 130-0026 (JP)
(74) Representative: Hoffmann Eitle
(86) International application number: PCT/JP2023/021653
(87) International publication number: WO 2024/004600

(57) **Abstract**

An object of the present invention is to provide a method for producing a laminate excellent in abrasion resistance and a method for producing a spectacle lens. The method for producing a laminate of the present invention includes: step 1 of forming an intermediate layer (c) on an antireflection layer of a substrate (s) including the antireflection layer by vapor deposition; and step 2 of forming a water-repellent layer (r) on the intermediate layer (c), wherein the intermediate layer (c) is a vapor-deposited layer of an organosilicon compound (C) having a silicon atom and having an amino group and/or an amine skeleton, the water-repellent layer (r) is a cured layer of a mixed composition (ca) of an organosilicon compound (A) in which a monovalent group having a perfluoropolyether structure is bonded to a silicon atom with a linking group interposed therebetween or without a linking group interposed therebetween, and a hydrolyzable group is bonded to the silicon atom with a linking group interposed therebetween or without a linking group interposed therebetween, and an average vapor deposition rate when the intermediate layer (c) is formed is 0.2 nm/s or more and less than 1.2 nm/s.

## Description

### TECHNICAL FIELD

The present disclosure relates to a method for producing a laminate and a method for producing a spectacle lens.

### BACKGROUND ART

Patent Literature 1 discloses a hard coat film in which a hard coat layer (X), a primer layer (Y), and a surface layer (Z) are laminated in this order on at least one surface of a substrate, wherein the surface layer (Z) has a water contact angle of 110° or more. It is also described that in order to form the surface layer (Z), a fluorine-based compound having a polyperfluoropolyether chain is preferably used, and in order to form the primer layer (Y), a silane compound such as 3-acryloxypropyltrimethoxysilane is preferably used.

### CITATION LIST

### PATENT LITERATURE

Patent Literature 1: JP 2015-120253 A

### SUMMARY OF INVENTION

The present disclosure relates to a method for producing a laminate, the method comprising: step 1 of forming an intermediate layer (c) on an antireflection layer of a substrate (s) including the antireflection layer by vapor deposition; and step 2 of forming a water-repellent layer (r) on the intermediate layer (c), wherein the intermediate layer (c) is a vapor-deposited layer of an organosilicon compound (C) having a silicon atom and having an amino group and/or an amine skeleton, the water-repellent layer (r) is a cured layer of a mixed composition (ca) of an organosilicon compound (A) in which a monovalent group having a perfluoropolyether structure is bonded to a silicon atom with a linking group interposed therebetween or without a linking group interposed therebetween, and a hydrolyzable group is bonded to the silicon atom with a linking group interposed therebetween or without a linking group interposed therebetween, and an average vapor deposition rate when the intermediate layer (c) is formed on the antireflection layer by the vapor deposition is 0.2 nm/s or more and less than 1.2 nm/s.

### DESCRIPTION OF EMBODIMENTS

Hereinafter, a method for producing a laminate of the present disclosure will be described in detail.

The laminate desirably exhibits excellent abrasion resistance for maintaining water repellency, and a production method capable of producing the laminate exhibiting the above characteristics with high productivity is required. The method for producing a laminate of the present disclosure can produce a laminate excellent in abrasion resistance with high productivity.

In the present disclosure, "can produce with high productivity" means that a difference in wear resistance between a plurality of laminates is small when the laminates are produced. In other words, the fact that the difference in abrasion resistance between the laminates is small means that a laminate exhibiting certain characteristics can be stably produced, that is, the productivity is excellent.

Although the description of components described below may be made based on representative embodiments of the present disclosure, the present disclosure is not limited to such embodiments.

In the present specification, a numerical range represented using "to" means a range including numerical values described before and after "to" as a lower limit value and an upper limit value.

Hereinafter, first, each step of the producing method of the present disclosure (hereinafter, also referred to as the present producing method) will be described, and then a laminate produced by the producing method (hereinafter, also simply referred to as a laminate) will be described.

### [Step 1]

The present producing method includes step 1 of forming an intermediate layer (c), which is a vapor-deposited layer of an organosilicon compound (C), on an antireflection layer of a substrate (s) including the antireflection layer by vapor deposition. An average vapor deposition rate at the time of forming the intermediate layer (c) is 0.2 nm/s or more and less than 1.2 nm/s.

Hereinafter, materials and members used in the present step, and a procedure will be described.

### [Substrate (s) Including Antireflection Layer]

A material of a portion other than an antireflection layer (ar) in the substrate (s) including the antireflection layer is not particularly limited, and may be either an organic material or an inorganic material. The antireflection layer (ar) may be provided on at least one surface. Examples of the organic material include thermoplastic resins such as an acrylic resin, a polycarbonate resin, a polyester resin, a styrene resin, an acryl-styrene copolymer resin, a cellulose resin, a polyolefin resin, and a vinyl-based resin (polyethylene, polyvinyl chloride, polystyrene, vinyl benzyl chloride-based resin, and polyvinyl alcohol and the like); and thermosetting resins such as a phenol resin, a urea resin, a melamine resin, an epoxy resin, an unsaturated polyester, and a silicone resin and a urethane resin. Examples of the inorganic material include metals such as iron, silicon, copper, zinc, and aluminum, alloys containing these metals, ceramics, and glass.

The laminate can be suitably used for, for example, a spectacle lens. In this case, in the substrate (s) including the antireflection layer, the antireflection layer (ar) is preferably formed on a glass layer (sg) or a resin layer (sp). The antireflection layer (ar) is preferably formed at least on the intermediate layer (c) side. Examples of a material contained in the resin layer (sp) include an allyl diglycol carbonate resin, a polycarbonate resin, a thiourethane resin, and an episulfide resin. A primer layer and/or a hard coat layer may be formed between the glass layer (sg) or the resin layer (sp) and the antireflection layer (ar).

The primer layer is a layer that improves adhesion between two layers laminated with the primer layer interposed therebetween, and a known material can be used for the primer layer.

The hard coat layer is a layer that imparts scratch resistance to the glass layer (sp) or the resin layer (sg), and exhibits a hardness of H or more in a pencil hardness according to a test method defined in JIS K5600. As the hard coat layer, a known hard coat layer can be used, and examples thereof include an organic hard coat layer, an inorganic hard coat layer, and an organic-inorganic hybrid hard coat layer.

The primer layer and the hard coat layer can be formed by, for example, a method in which a precursor composition is applied to a substrate and cured, and a method in which a water-repellent layer (r) described later is formed can be used.

The antireflection layer (ar) is a layer having a function of preventing the reflection of incident light, and specifically, is preferably a layer exhibiting a reflection characteristic in which a reflectance is reduced to about 5.0% or less in a visible light region of 530 nm.

The structure of the antireflection layer (ar) is not particularly limited, and may be a single layer structure or a multilayer structure. In the case of the multilayer structure, it is preferable to have a structure in which a low refractive index layer and a high refractive index layer are alternately laminated. Examples of a material constituting the high refractive index layer include oxides of titanium, zirconium, aluminum, tantalum, and lanthanum, and examples of a material constituting the low refractive index layer include silica. The antireflection layer (ar) having a multilayer structure preferably has a structure in which SiO₂ and ZrO₂ are alternately laminated and the outermost layer on the side opposite to the glass layer (sg) or the resin layer (sp) is SiO₂. The antireflection layer (ar) can be formed by, for example, a vapor deposition method.

The thickness of the substrate (s) is, for example, 0.9 to 10 mm. When the thickness of the substrate (s) is not uniform, the thickness at the center of gravity of the substrate (s) may be in the above range.

### <Organosilicon Compound (C)>

The organosilicon compound (C) is an organosilicon compound having a silicon atom and having an amino group and/or an amine skeleton.

A hydroxy group or a hydrolyzable group is preferably bonded to the silicon atom of the organosilicon compound (C).

Examples of the hydrolyzable group bonded to the silicon atom contained in the organosilicon compound (C) include an alkoxy group, a halogen atom, a cyano group, an acetoxy group, and an isocyanate group, and an alkoxy group is preferable, and an alkoxy group having 1 to 4 carbon atoms is more preferable.

Examples of the organosilicon compound (C) include an organosilicon compound (C1) represented by the following formula (c1), an organosilicon compound (C2) represented by the following formula (c2), and an organosilicon compound (C3) represented by the following formula (c3).

### <Organosilicon Compound (C1)>

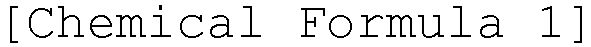

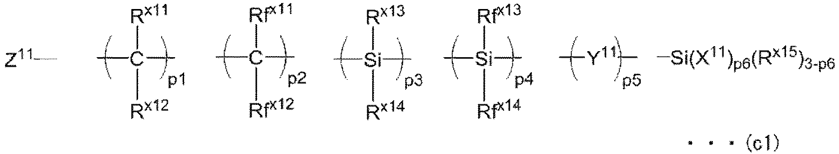

In the formula (c1),
R^{x11}, R^{x12}, R^{x13}, and R^{x14} each independently represent a hydrogen atom or an alkyl group having 1 to 4 carbon atoms, when a plurality of R^{x11}s are present, the plurality of R^{x11}s may be different from each other, when a plurality of R^{x12}s are present, the plurality of R^{x12}s may be different from each other, when a plurality of R^{x13}s are present, the plurality of R^{x13}s may be different from each other, and when a plurality of R^{x14}s are present, the plurality of R^{x14}s may be different from each other,
Rf^{x11}, Rf^{x12}, R^{fx13}, and Rf^{x14} each independently represent a fluorine atom, or an alkyl group having 1 to 20 carbon atoms in which one or more hydrogen atoms are substituted by a fluorine atom, when a plurality of Rf^{x11}s are present, the plurality of Rf^{x11} may be different from each other, when a plurality of Rf^{x12}s are present, the plurality of Rf^{x12}s may be different from each other, when a plurality of Rf^{x13}s are present, the plurality of Rf^{x13}s may be different from each other, and when a plurality of Rf^{x14}s are present, the plurality of Rf^{x14}s may be different from each other,
R^{x15} represents an alkyl group having 1 to 20 carbon atoms, and when a plurality of R^{x15}s are present, the plurality of R^{x15}s may be different from each other,
X¹¹ represents a hydrolyzable group, and when a plurality of X¹¹s are present, the plurality of X¹¹s may be different from each other,
Y¹¹ represents -NH- or -S-, and when a plurality of Y¹¹s are present, the plurality of Y¹¹s may be different from each other,
Z¹¹ represents a vinyl group, an α-methylvinyl group, a styryl group, a methacryloyl group, an acryloyl group, an amino group, an isocyanate group, an isocyanurate group, an epoxy group, a ureido group, or a mercapto group,
p1 represents an integer of 1 to 20, p2, p3, and p4 each independently represent an integer of 0 to 10, p5 represents an integer of 1 to 10,
p6 represents an integer of 1 to 3,
when Z¹¹ does not represent an amino group, at least one of Y¹¹s represents -NH-, and when all of Y¹¹s represent -S-, Z¹¹ represents an amino group, and
Z¹¹-; -Si(X¹¹)ₚ₆(R^{x15})₃₋ₚ₆; -{C(R^{x11})(R^{x12})}- whose number is p1; -{C(Rf^{x11})(Rf^{x12})}- whose number is p2; - {Si(R^{x13})(R^{x14})}- whose number is p3; -{Si(Rf^{x13})(Rf^{x14})}-whose number is p4; and -Y¹¹- whose number is p5 are aligned and bonded in any order as long as Z¹¹- and - Si(X¹¹)ₚ₆(R^{x15})₃₋ₚ₆ are located at ends and -O- does not link to -O-.

R^{x11}, R^{x12}, R^{x13}, and R^{x14} preferably represent a hydrogen atom.

Preferably, Rf^{x11}, Rf^{x12}, Rf^{x13}, and Rf^{x14} each independently represent a fluorine atom, or an alkyl group having 1 to 10 carbon atoms in which one or more hydrogen atoms are substituted by a fluorine atom.

R^{x15} preferably represents an alkyl group having 1 to 5 carbon atoms.

X¹¹ preferably represents an alkoxy group, a halogen atom, a cyano group, or an isocyanate group, more preferably represents an alkoxy group, and still more preferably represents a methoxy group or an ethoxy group.

Y¹¹ preferably represents -NH-.

Z¹¹ preferably represents a methacryloyl group, an acryloyl group, a mercapto group, or an amino group, more preferably represents a mercapto group or an amino group, and still more preferably represents an amino group.

p1 preferably represents 1 to 15, and more preferably represents 2 to 10. Preferably, p2, p3 and p4 each independently represent 0 to 5, and more preferably, all of p2, p3 and p4 represent 0 to 2. p5 preferably represents 1 to 5, and more preferably represents 1 to 3. p6 preferably represents 2 to 3, and more preferably represents 3.

As the organosilicon compound (C1), it is preferable to use a compound in which, in the formula (c1), R^{x11} and R^{x12} each represent a hydrogen atom, Y¹¹ represents -NH-, X¹¹ represents an alkoxy group (in particular, a methoxy group or an ethoxy group), Z¹¹ represents an amino group or a mercapto group, p1 represents 1 to 10, p2, p3, and p4 each represent 0, p5 represents 1 to 5 (in particular, 1 to 3), and p6 represents 3.

The organosilicon compound (C1) is preferably a compound represented by the following formula (c1-2).
[Chemical Formula 2]

Z¹²-C_{q}H_{2q}-Y¹²-CᵣH₂ᵣ-Si(X¹²)ₚ(R^{x16})₃₋ₚ ··· (c1-2)

In the above formula (c1-2),
X¹² represents a hydrolyzable group, when a plurality of X¹²s are present, the plurality of X¹²s may be different from each other,
Y¹² represents -NH-,
Z¹² represents an amino group or a mercapto group,
R^{x16} represents an alkyl group having 1 to 20 carbon atoms, and when a plurality of R^{x16}s are present, the plurality of R^{x16}s may be different from each other,
p represents an integer of 1 to 3, q represents an integer of 2 to 5, and r represents an integer of 0 to 5.

X¹² preferably represents an alkoxy group, a halogen atom, a cyano group, or an isocyanate group, and more preferably represents an alkoxy group.

Z¹² preferably represents an amino group.

R^{x16} preferably represents an alkyl group having 1 to 10 carbon atoms, and more preferably represents an alkyl group having 1 to 5 carbon atoms.

p preferably represents an integer of 2 to 3, and more preferably represents 3.

q preferably represents an integer of 2 to 3, and r preferably represents an integer of 2 to 4.

### <Organosilicon Compound (C2)>

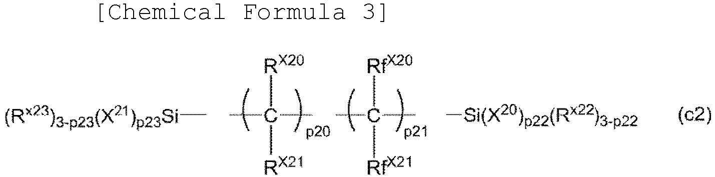

In the formula (c2),
R^{x20} and R^{x21} each independently represent a hydrogen atom or an alkyl group having 1 to 4 carbon atoms, when a plurality of R^{x20}s are present, the plurality of R^{x20}s may be different from each other, and when a plurality of R^{x21}s are present, the plurality of R^{x21}s may be different from each other,
Rf^{x20} and Rf^{x21} each independently represent a fluorine atom, or an alkyl group having 1 to 20 carbon atoms in which one or more hydrogen atoms are substituted by a fluorine atom, when a plurality of Rf^{x20}s are present, the plurality of Rf^{x20}s may be different from each other, and when a plurality of Rf^{x21}s are present, the plurality of Rf^{x21}s may be different from each other,
R^{x22} and R^{x23} each independently represent an alkyl group having 1 to 20 carbon atoms, and when a plurality of R^{x22}s and R^{x23}s are present, the plurality of R^{x22}s and R^{x23}s may be different from each other,
X²⁰ and X²¹ each independently represent a hydrolyzable group, and when a plurality of X²⁰s and X²¹s are present, the plurality of X²⁰s and X²¹s may be different from each other,
p20 represents an integer of 1 to 30, p21 represents an integer of 0 to 30, at least one of repeating units bracketed with p20 or p21 is replaced by an amine skeleton -NR¹⁰⁰-, and R¹⁰⁰ in the amine skeleton represents a hydrogen atom or an alkyl group,
p22 and p23 each independently represent an integer of 1 to 3, and
-{C(R^{x20})(R^{x21})}- whose number is p20 and - {C(Rf^{x20})(Rf^{x21})}- whose number is p21 are aligned and bonded in any order, p20 or p21 units may not necessarily be continuous, and both ends are -Si (X²⁰)ₚ₂₂(R^{x22})₃₋ₚ₂₂ and - Si(X²¹)ₚ₂₃(R^{x23})₃₋ₚ₂₃.

R^{x20} and R^{x21} preferably represent a hydrogen atom.

Preferably, Rf^{x20} and Rf^{x21} each independently represent a fluorine atom, or an alkyl group having 1 to 10 carbon atoms in which one or more hydrogen atoms are substituted by a fluorine atom.

R^{x22} and R^{x23} preferably represent an alkyl group having 1 to 5 carbon atoms.

X²⁰ and X²¹ preferably represent an alkoxy group, a halogen atom, a cyano group, or an isocyanate group, more preferably represent an alkoxy group, and still more preferably represent a methoxy group or an ethoxy group.

As described above, at least one amine skeleton - NR¹⁰⁰- may be present in the molecule. Any of the repeating units bracketed with p20 or p21 may be replaced by the amine skeleton, but a part of the repeating unit bracketed with p20 is preferably replaced. A plurality of amine skeletons may be present. In this case, the number of the amine skeletons is preferably 1 to 10, more preferably 1 to 5, and still more preferably 2 to 5. In this case, an alkylene group is preferably located between the amine skeletons adjacent to each other, and the number of carbon atoms of the alkylene group is preferably 1 to 10, and more preferably 1 to 5. The number of the carbon atoms in the alkylene group between the amine skeletons adjacent to each other is included in the total number of p20 or p21.

When R¹⁰⁰ represents an alkyl group in the amine skeleton -NR¹⁰⁰-, the number of carbon atoms is preferably 5 or less, and more preferably 3 or less. The amine skeleton -NR¹⁰⁰- preferably represents -NH- (R¹⁰⁰ represents a hydrogen atom).

p20 preferably represents 1 to 15, and more preferably represents 1 to 10, excluding the number of the repeating units replaced by the amine skeletons.

p21 preferably represents 0 to 5, and more preferably represents 0 to 2, excluding the number of the repeating units replaced by the amine skeletons.

p22 and p23 preferably represent 2 to 3, and more preferably represents 3.

As the organosilicon compound (C2), in the formula (c2), it is preferable to use a compound in which R^{x20} and R^{x21} each represent a hydrogen atom, X²⁰ and X²¹ represent an alkoxy group (in particular, a methoxy group or an ethoxy group), a repeating unit bracketed with p20 is replaced by at least one amine skeleton -NR¹⁰⁰-, R¹⁰⁰ represents a hydrogen atom, p20 represents 1 to 10 (excluding the number of the repeating units replaced by the amine skeletons), p21 represents 0, and p22 and p23 represent 3.

The organosilicon compound (C2) is preferably a compound represented by the following formula (c2-2).
[Chemical Formula 4]

(R^{x25})₃₋ₚ₂₅(X²³)ₚ₂₅Si-C_{w}H_{2w}-Si(X²²)ₚ₂₄(R^{x24})₃₋ₚ₂₄ (c2-2)

In the formula (c2-2),
X²² and X²³ each independently represent a hydrolyzable group, and when a plurality of X²²s and X²³s are present, the plurality of X²²s and X²³s may be different from each other,
R^{x24} and R^{x25} each independently represent an alkyl group having 1 to 20 carbon atoms, and when a plurality of R^{x24}s and R^{x25}s are present, the plurality of R^{x24}s and R^{x25}s may be different from each other,
at least one methylene group that is a part of -C_{w}H_{2w}-is replaced by an amine skeleton -NR¹⁰⁰-, and R¹⁰⁰ represents a hydrogen atom or an alkyl group,
w represents an integer of 1 to 30 (excluding the number of the methylene groups replaced by the amine skeletons), and
p24 and p25 each independently represent an integer of 1 to 3.

X²² and X²³ preferably represent an alkoxy group, a halogen atom, a cyano group, or an isocyanate group, more preferably represents an alkoxy group, and still more preferably represents an alkoxy group having carbon 1 to 4 atoms (in particular, a methoxy group or an ethoxy group).

A plurality of amine skeletons -NR¹⁰⁰- may be present. In this case, the number of the amine skeletons is preferably 1 to 10, more preferably 1 to 5, and still more preferably 2 to 5. In this case, an alkylene group is preferably located between the amine skeletons adjacent to each other. The number of carbon atoms in the alkylene group is preferably 1 to 10, and more preferably 1 to 5. The number of carbon atoms in the alkylene group between the amine skeletons adjacent to each other is included in the total number of w.

When R¹⁰⁰ represents an alkyl group in the amine skeleton -NR¹⁰⁰-, the number of carbon atoms is preferably 5 or less, and more preferably 3 or less. The amine skeleton -NR¹⁰⁰- preferably represents -NH- (R¹⁰⁰ represents a hydrogen atom).

R^{x24} and R^{x25} preferably represent an alkyl group having 1 to 10 carbon atoms, and more preferably represents an alkyl group having 1 to 5 carbon atoms.

p24 and p25 preferably represent an integer of 2 to 3, and more preferably represents 3.

w preferably represents 1 or more, more preferably represents 2 or more, and preferably represents 20 or less, more preferably represents 10 or less.

### <Organosilicon Compound (C3)>

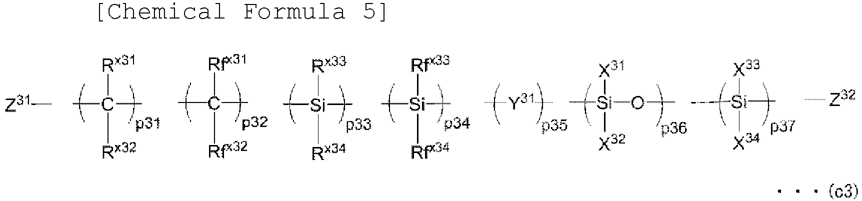

In the formula (c3),
Z³¹ and Z³² each independently represent a reactive functional group other than a hydrolyzable group and a hydroxy group. Examples of the reactive functional group include a vinyl group, an α-methylvinyl group, a styryl group, a methacryloyl group, an acryloyl group, an amino group, an epoxy group, a ureido group, and a mercapto group. Z³¹ and Z³² preferably represent an amino group, a mercapto group, or a methacryloyl group, and particularly preferably represent an amino group.

R^{x31}, R^{x32}, R^{x33}, and R^{x34} each independently represent a hydrogen atom or an alkyl group having 1 to 4 carbon atoms, when a plurality of R^{x31}s are present, the plurality of R^{x31}s may be different from each other, when a plurality of R^{x32}s are present, the plurality of R^{x32}s may be different from each other, when a plurality of R^{x33}s are present, the plurality of R^{x33}s may be different from each other, and when a plurality of R^{x34}s are present, the plurality of R^{x34}s may be different from each other. R^{x31}, R^{x32}, R^{x33}, and R^{x34} preferably represent a hydrogen atom or an alkyl group having 1 to 2 carbon atoms, and more preferably represent a hydrogen atom.

Rf^{x31}, Rf^{x32}, Rf^{x33}, and Rf^{x34} each independently represent a fluorine atom, or an alkyl group having 1 to 20 carbon atoms in which one or more hydrogen atoms are substituted by a fluorine atom, when a plurality of Rf^{x31}s are present, the plurality of Rf^{x31}s may be different from each other, when a plurality of Rf^{x32}s are present, the plurality of Rf^{x32}s may be different from each other, when a plurality of Rf^{x33}s are present, the plurality of Rf^{x33}s may be different from each other, and when a plurality of Rf^{x34}s are present, the plurality of Rf^{x34}s may be different from each other. Preferably, Rf^{x31}, Rf^{x32}, Rf^{x33}, and Rf^{x34} each independently represent a fluorine atom, or an alkyl group having 1 to 10 carbon atoms in which one or more hydrogen atoms are substituted by a fluorine atom.

Y³¹ represents -NH-, -N(CH₃)-, or -O-, and when a plurality of Y³¹s are present, the plurality of Y³¹s may be different from each other. Y³¹ preferably represents -NH-.

X³¹, X³², X³³, and X³⁴ each independently represent -OR^{c} (R^{c} represents a hydrogen atom, an alkyl group having 1 to 4 carbon atoms, or an amino C₁₋₃ alkyl di C₁₋₃ alkoxysilyl group), when a plurality of X³¹s are present, the plurality of X³¹s may be different from each other, when a plurality of X³²s are present, the plurality of X³²s may be different from each other, when a plurality of X³³s are present, the plurality of X³³s may be different from each other, and when a plurality of X³⁴s are present, the plurality of X³⁴s may be different from each other. X³¹, X³², X³³, and X³⁴ preferably represent -OR^{c} in which R^{c} represents a hydrogen atom or an alkyl group having 1 to 2 carbon atoms, and R^{c} more preferably represent a hydrogen atom.

p31 represents an integer of 0 to 20, p32, p33, and p34 each independently represent an integer of 0 to 10, p35 represents an integer of 0 to 5, p36 represents an integer of 1 to 10, and p37 represents 0 or 1. p31 preferably represents 1 to 15, more preferably represents 3 to 13, and still more preferably represents 5 to 10. Preferably, p32, p33, and p34 each independently represent 0 to 5. All of p32, p33, and p34 more preferably represent 0 to 2. p35 preferably represents 1 to 5, and more preferably represents 1 to 3. p36 preferably represents 1 to 5, and more preferably represents 1 to 3. p37 preferably represents 1.

The organosilicon compound (C3) is structured such that -{C(R^{x31})(R^{x32})}- whose number is p31; -{C(Rf^{x31})(Rf^{x32})}-whose number is p32; -{Si(R^{x33})(R^{x34})}- whose number is p33; -{Si(Rf^{x33})(Rf^{x34})}- whose number is p34; -Y³¹- whose number is p35; -{Si(X³¹)(X³²)-O}- whose number is p36; and - {Si(X³³)(X³⁴)}- whose number is p37 are aligned and bonded in any order as long as a condition that at least one of Z³¹ and Z³² represents an amino group or at least one of Y³¹s represents -NH- or -N(CH₃)- is satisfied, the ends are Z³¹-and Z³²-, and -O- does not link to -O-. Regarding - {C(R^{x31})(Rx³²)}- whose number is p31, the units of - {C(Rx³¹)(R^{x32})}- may not necessarily be continuously bonded, and may be bonded with another unit interposed therebetween as long as the total number of the units of -{C(R^{x31})(R^{x32})}-is p31. The same applies to units bracketed with each of p32 to p37.

The organosilicon compound (C3) is preferably a compound represented by the formula (c3) in which Z³¹ and Z³² represent an amino group, R^{x31} and R^{x32} represent a hydrogen atom, p31 represents 3 to 13 (preferably 5 to 10), R^{x33} and R^{x34} each represent a hydrogen atom, Rf^{x31} to Rf^{x34} each represent a fluorine atom, or an alkyl group having 1 to 10 carbon atoms in which one or more hydrogen atoms are substituted by a fluorine atom, p32 to p34 each represent 0 to 5, Y³¹ represents -NH-, p35 represents 0 to 5 (preferably 0 to 3), X³¹ to X³⁴ each represents -OH, p36 represents 1 to 5 (preferably 1 to 3), and p37 represents 1.

The organosilicon compound (C3) is preferably a compound represented by the following formula (c3-2).

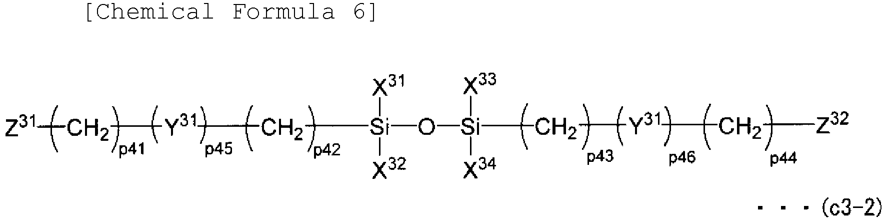

In the above formula (c3-2),
Z³¹, Z³², X³¹, X³², X³³, X³⁴, and Y³¹ have the same meanings as those in the formula (c3), p41 to p44 each independently represent an integer of 1 to 6, and p45 and 46 each independently represent 0 or 1.

In the formula (c3-2), Z³¹ and Z³² preferably represent an amino group, a mercapto group, or a methacryloyl group, and particularly preferably represent an amino group. X³¹, X³², X³³, and X³⁴ preferably represent - OR^{c} in which R^{c} is a hydrogen atom or an alkyl group having 1 to 2 carbon atoms, and R^{c} more preferably represent a hydrogen atom. Y³¹ preferably represents -NH-. p41 to p44 preferably represent 2 or more, and preferably represent 5 or less, more preferably represent 4 or less. p45 and p46 each preferably represent 0.

The organosilicon compound (C) is preferably at least one selected from the group consisting of an organosilicon compound (C1) and an organosilicon compound (C2), more preferably an organosilicon compound (C2), and still more preferably a compound represented by the formula (c2-2).

As the organosilicon compound (C), only one kind may be used, or two or more kinds may be used.

### [Procedure of Step 1]

Step 1 is a step of forming the intermediate layer (c) on the antireflection layer of the substrate (s) including the antireflection layer by vapor deposition. The intermediate layer (c) is a vapor-deposited layer of an organosilicon compound (C) having a silicon atom and having an amino group and/or an amine skeleton.

The organosilicon compound (C) used for vapor deposition is as described above.

As the vapor deposition method, a known method can be used, and examples thereof include a vacuum vapor deposition method. The vacuum vapor deposition method is a method in which a vapor deposition source is evaporated in a vacuum chamber and attached to the surface of a substrate.

A degree of vacuum in the vacuum deposition method is preferably 1.0×10⁻¹ Pa or less, more preferably 5.0×10⁻² Pa or less, and still more preferably 2.0×10⁻² Pa or less, in terms of pressure during vapor deposition. The lower limit of the degree of vacuum is not particularly limited, and is often 1.0×10⁻⁴ Pa or more.

Examples of the evaporation method of the vapor deposition source in the vacuum vapor deposition method include an electron beam method, a resistance heating method, a heater heating method, and an induction heating method, and an electron beam method is preferable from the viewpoint of energy conversion efficiency.

The output of an electron beam may be appropriately adjusted according to raw materials and substrate to be used, a vapor deposition apparatus, a degree of vacuum, an irradiation area, and an average vapor deposition rate, and for example, a beam current is preferably 6 to 36 mA.

The average vapor deposition rate when the organosilicon compound (C) is vapor-deposited on the antireflection layer of the substrate (s) including the antireflection layer is 0.2 nm/s or more and less than 1.2 nm/s (0.20 nm/s or more and less than 1.20 nm/s), preferably 0.2 nm/s to 1.15 nm/s, and more preferably 0.2 nm/s to 1.1 nm/s.

The average vapor deposition rate is a value (average vapor deposition rate (nm/s) = film thickness (nm)/vapor deposition time (s)) obtained by dividing the film thickness of a vapor-deposited film by a vapor deposition time required to form the vapor-deposited film having the above film thickness.

When the average vapor deposition rate is 1.2 nm/s or more, abrasion resistance and productivity are deteriorated, and when the average vapor deposition rate is less than 0.2 nm/s, productivity is deteriorated, which is not preferable.

### [Intermediate Layer (c)]

The intermediate layer (c) is a vapor-deposited layer of the organosilicon compound (C). The vapor deposition method is as described above.

The intermediate layer (c) is a vapor-deposited layer of an organosilicon compound (C) having a silicon atom and having an amino group or an amine skeleton (-NR¹⁰⁰-, wherein R¹⁰⁰ is a hydrogen atom or an alkyl group), and the intermediate layer (c) has an amino group or an amine skeleton. In a preferable aspect, a hydrolyzable group or a hydroxy group is bonded to the silicon atom of the organosilicon compound (C), and Si-OH groups of the organosilicon compound (C) and/or Si-OH groups generated by hydrolysis of the hydrolyzable group bonded to the silicon atom are dehydration-condensed, so that the intermediate layer (c) preferably has a condensed structure derived from the organosilicon compound (C). The intermediate layer (c) can function as a primer layer of the water-repellent layer (r).

The thickness of the intermediate layer (c) is, for example, about 1 to 1000 nm. Among them, the thickness is preferably 5 nm or more, more preferably 10 nm or more, and still more preferably 20 nm, and is preferably 100 nm or less, more preferably 80 nm or less, and still more preferably 50 nm or less.

### [Step 2]

The present producing method includes step 2 of forming a water-repellent layer (r) on the intermediate layer (c) obtained in the step 1. The water-repellent layer (r) is a cured layer of a mixed composition (ca) of an organosilicon compound (A) in which a monovalent group having a perfluoropolyether structure is bonded to a silicon atom with or without a linking group interposed therebetween, and a hydrolyzable group is bonded to a silicon atom with or without a linking group interposed therebetween. Among them, the mixed composition (ca) is preferably a mixed composition of the organosilicon compound (A) and an organosilicon compound (B) described later.

Hereinafter, materials and a procedure used in the present step will be described.

### <Organosilicon Compound (A)>

The organosilicon compound (A) is a compound in which a monovalent group having a perfluoropolyether structure is bonded to a silicon atom with or without a linking group interposed therebetween, and a hydrolyzable group is bonded to the silicon atom with or without a linking group interposed therebetween. The water-repellent layer (r) is obtained by applying and curing the mixed composition (ca), and has a structure derived from the organosilicon compound (A). As described above, the organosilicon compound (A) has a hydrolyzable group bonded to a silicon atom (may be bonded with a linking group interposed therebetween), and - SiOH groups (Si and OH may be bonded with a linking group interposed therebetween) of the organosilicon compound (A) generated by hydrolysis dehydrate and condense with each other, so that the water-repellent layer (r) usually has a condensed structure derived from the organosilicon compound (A). Examples of the hydrolyzable group include an alkoxy group, a halogen atom, a cyano group, an acetoxy group, and an isocyanate group.

The perfluoropolyether structure can also be referred to as a perfluorooxyalkylene group. The perfluoropolyether structure has liquid repellency such as water repellency or oil repellency. The number of carbon atoms contained in the longest straight chain portion of the perfluoropolyether structure is, for example, preferably 5 or more, more preferably 10 or more, and still more preferably 20 or more. The upper limit of the number of carbon atoms is not particularly limited, and may be, for example, about 200. Furthermore, the monovalent group having the perfluoropolyether structure in the organosilicon compound (A) preferably has a perfluoroalkyl group at a free end.

The water-repellent layer (r) can also be represented as a layer having a perfluoropolyether structure and a polysiloxane skeleton, and preferably further includes a perfluoroalkyl group. The water-repellent layer (r) preferably has a structure in which a monovalent group having a perfluoroalkyl group at a free end and the perfluoropolyether structure is bonded to a part of silicon atoms of the polysiloxane skeleton. The presence of the perfluoroalkyl group at the free end side improves the water repellency of the water-repellent layer (r).

The number of carbon atoms (in particular, the number of carbon atoms in the longest linear chain portion) of the perfluoroalkyl group is, for example, preferably 3 or more, more preferably 5 or more, and still more preferably 7 or more. The upper limit of the number of carbon atoms is not particularly limited, and may be, for example, about 20. Also in this case, excellent water repellent properties are exhibited.

The perfluoroalkyl group may be bonded to a hydrocarbon group and/or a group in which at least a part of hydrogen atoms in a hydrocarbon group is substituted by a fluorine atom to form a fluorine-containing group such as a fluoroalkyl group. For example, CF₃(CF₂)ₘ-(CH₂)ₙ- and CF₃(CF₂)ₘ-C₆H₄- (m each represents 1 to 10, and preferably represents 3 to 7, n each represents 1 to 5, and preferably represents 2 to 4), and CF₃(CF₂)ₘ-(CH₂)ₙ- (m each represents 1 to 10, and preferably represents 3 to 7, and n each represents 1 to 5, and preferably represents 2 to 4) are preferable. The perfluoroalkyl group is more preferably directly bonded to the perfluoropolyether structure.

In the organosilicon compound (A), a monovalent group having a perfluoropolyether structure and a silicon atom may be bonded with an appropriate linking group interposed therebetween, and the monovalent group having a perfluoropolyether may be directly bonded to a silicon atom without a linking group interposed therebetween. Examples of the linking group include hydrocarbon groups such as an alkylene group and an aromatic hydrocarbon group, a (poly)alkylene glycol group, or a group in which a part of hydrogen atoms in these groups is substituted by F or a substituent, and a group in which these groups are appropriately linked. The number of carbon atoms in the linking group is, for example, 1 or more and 20 or less, and preferably 2 or more and 15 or less.

The hydrolyzable group has an action of bonding the organosilicon compounds (A) to each other or bonding the organosilicon compound (A) to active hydrogen (hydroxyl group or the like) on the surface of the substrate through a hydrolysis/dehydration condensation reaction. Examples of such a hydrolyzable group include an alkoxy group (in particular, an alkoxy group having 1 to 4 carbon atoms), a hydroxy group, an acetoxy group, and a halogen atom (in particular, a chlorine atom). The hydrolyzable group is preferably an alkoxy group and a halogen atom, and is particularly preferably a methoxy group, an ethoxy group, and a chlorine atom.

The hydrolyzable group may be bonded to a silicon atom with a linking group interposed therebetween, or may be directly bonded to a silicon atom without a linking group interposed therebetween. The number of the hydrolyzable groups bonded to the silicon atom may be 1 or more, and may be 2 or 3, but is preferably 2 or 3, and particularly preferably 3. When two or more hydrolyzable groups are bonded to a silicon atom, different hydrolyzable groups may be bonded to the silicon atom, but it is preferable that the same hydrolyzable groups are bonded to the silicon atom. The total of the number of fluorine-containing groups bonded to the silicon atom and the number of hydrolyzable groups bonded to the silicon atom is usually 4, but may be 2 or 3 (in particular, 3). When the total number is 3 or less, a monovalent group other than the hydrolyzable group may be bonded to a remaining bond, and for example, an alkyl group (in particular, an alkyl group having 1 to 4 carbon atoms), H, or NCO or the like can be bonded.

The monovalent group having the perfluoropolyether structure in the organosilicon compound (A) may be linear or may have a side chain, and is preferably linear.

One example of the organosilicon compound (A) is a compound represented by the following formula (a).

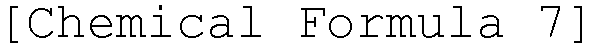

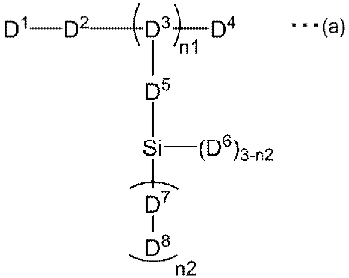

In the above formula (a), D¹ represents a monovalent group having a perfluoropolyether structure, an end of D¹ on the side bonded to D² is -CF₂-O-* or -CFD⁹-* (* represents a bond on the D² side), D² represents a single bond or a divalent hydrocarbon group which is not substituted by a fluorine atom, D³ represents a trivalent hydrocarbon group which is not substituted by a fluorine atom, a part of methylene groups in the hydrocarbon group may be replaced by an oxygen atom, D⁴ represents a hydrogen atom or a fluorine atom, D⁵ represents a single bond or a divalent hydrocarbon group, D⁶ represents a monovalent group other than a hydrolyzable group, D⁷ represents a divalent group or a single bond, D⁸ represents a hydrolyzable group, D⁹ represents a hydrogen atom, a fluorine atom, or a hydrocarbon group, n1 represents 1 to 30, and n2 represents 1 to 3. Examples of the hydrolyzable group as D⁸ include the above-described groups.

The organosilicon compound (A) is preferably a compound represented by the following formula (a1).

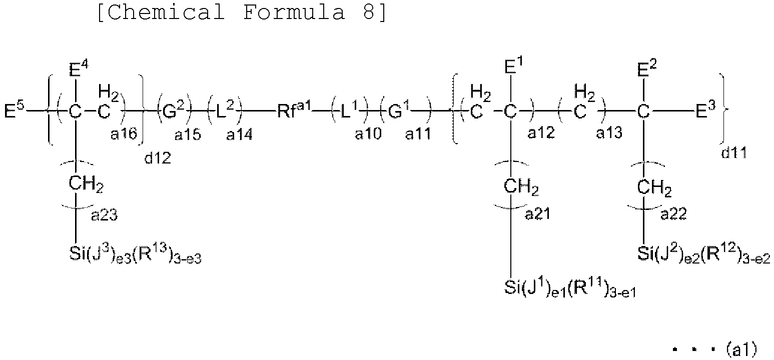

In the formula (a1),
Rf^{a1} represents a divalent perfluoropolyether structure having oxygen atoms at both ends,
R¹¹, R¹², and R¹³ each independently (that is, R¹¹, R¹², and R¹³ may be the same or may be different from each other) represent an alkyl group having 1 to 20 carbon atoms, when a plurality of R¹¹s are present, the plurality of R¹¹s may be different from each other, when a plurality of R¹²s are present, the plurality of R¹²s may be different from each other, and when a plurality of R¹³s are present, the plurality of R ¹³s may be different from each other,
E¹, E², E³, E⁴, and E⁵ each independently represent a hydrogen atom or a fluorine atom, when a plurality of E¹s are present, the plurality of E¹s may be different from each other, when a plurality of E²s are present, the plurality of E²s may be different from each other, when a plurality of E³s are present, the plurality of E³s may be different from each other, and when a plurality of E⁴s are present, the plurality of E⁴s may be different from each other,
G¹ and G² each independently represent a divalent to decavalent organosiloxane group having a siloxane bond,
J¹, J², and J³ each independently represent a hydrolyzable group or -(CH₂)ₑ₆-Si(OR¹⁴)₃, e6 represents 1 to 5, R¹⁴ represents a methyl group or an ethyl group, when a plurality of J¹s are present, the plurality of J¹s may be different from each other, when a plurality of J²s are present, the plurality of J²s may be different from each other, and when a plurality of J³s are present, the plurality of J³s may be different from each other,
L¹ and L² each independently represent a divalent linking group having 1 to 12 carbon atoms, which may contain an oxygen atom, a nitrogen atom, or a fluorine atom, when a plurality of L¹s are present, the plurality of L¹s may be different from each other, and when a plurality of L²s are present, the plurality of L²s may be different from each other,
d11 represents 1 to 9,
d12 represents 0 to 9,
a10 and a14 each independently represent 0 to 10,
a11 and a15 each independently represent 0 or 1,
a12 and a16 each independently represent 0 to 9,
a13 represents 0 or 1,
a21, a22, and a23 each independently represent 0 to 2, and
e1, e2, and e3 each independently represent 1 to 3.

The organosilicon compound (A) has the perfluoropolyether structure represented by Rf^{a1} and has at least one of a hydrolyzable group or -(CH₂)ₑ₆-Si(OR¹⁴)₃ (where R¹⁴ represents a methyl group or an ethyl group) represented by J², as represented by the above formula (a1). The perfluoropolyether structure is a structure in which all hydrogen atoms in a polyoxyalkylene group are replaced by fluorine atoms, is also referred to as a perfluorooxyalkylene group, and can impart water repellency to the obtained coating film. The organosilicon compounds (A) are bonded to each other by J² or the organosilicon compound (A) and another monomer are bonded by J², through a polymerization reaction (in particular, a polycondensation reaction), to allow the organosilicon compound (A) to become a matrix of the obtained coating film.

Rf^{a1} preferably represents -O-(CF₂CF₂O)ₑ₄- or -O-(CF₂CF₂CF₂O)ₑ₅-. e4 and e5 each represent 15 to 80.

Preferably, R¹¹, R¹², and R¹³ each independently represent an alkyl group having 1 to 10 carbon atoms.

Preferably, L¹ and L² each independently represent a divalent linking group having 1 to 5 carbon atoms and containing a fluorine atom.

Preferably, G¹ and G² each independently represent a divalent to pentavalent organosiloxane group having a siloxane bond.

Preferably, J¹, J², and J³ each independently represent a methoxy group, an ethoxy group, or -(CH₂)ₑ₆-Si(OR¹⁴)₃.

a10 preferably represents 0 to 5 (more preferably 0 to 3), a11 preferably represents 0, a12 preferably represents 0 to 7 (more preferably 0 to 5), a14 preferably represents 1 to 6 (more preferably 1 to 3), a15 preferably represents 0, a16 preferably represents 0 to 6, a21 to a23 each preferably represent 0 or 1 (more preferably 0), d11 preferably represents 1 to 5 (more preferably 1 to 3), d12 preferably represents 0 to 3 (more preferably 0 or 1), and e1 to e3 each preferably represent 3. a13 preferably represents 1.

The organosilicon compound (A) to be used is preferably a compound in which, in the above formula (a1), Rf^{a1} represents -O-(CF₂CF₂CF₂O)ₑ₅-, e5 represents 35 to 50, L¹ and L² each represent a perfluoroalkylene group having 1 to 3 carbon atoms, E¹, E², and E³ each represent a hydrogen atom, E⁴ and E⁵ each represent a hydrogen atom or a fluorine atom, J¹, J² and J³ each represent a methoxy group or an ethoxy group (in particular, a methoxy group), a10 represents 1 to 3, a11 represents 0, a12 represents 0 to 5, a13 represents 1, a14 represents 2 to 5, a15 represents 0, a16 represents 0 to 6, a21 to a23 each independently represent 0 or 1 (more preferably, all of a21 to a23 represent 0), d11 represents 1, d12 represents 0 or 1, and e1 to e3 each represent 3.

The organosilicon compound (A) to be used is also preferably a compound in which, in the above formula (a1), Rf^{a1} represents -O-(CF₂CF₂CF₂O)ₑ₅-, e5 represents 25 to 40, L¹ represents a divalent linking group having 3 to 6 carbon atoms, which contains a fluorine atom and an oxide atom, L² represents a perfluoroalkylene group having 1 to 3 carbon atoms, E² and E³ each represent a hydrogen atom, E⁵ represents a fluorine atom, J² represents -(CH₂)ₑ₆-Si(OCH₃)₃, e6 represents 2 to 4, a10 represents 1 to 3, a11 represents 0, a12 represents 0, a13 represents 0, a14 represents 2 to 5, a15 represents 0, a16 represents 0, a21 to a23 each independently represent 0 or 1 (more preferably, all of a21 to a23 represent 0), d11 represents 1, d12 represents 0, and e2 represents 3.

The organosilicon compound (A) is also preferably a compound represented by the following formula (a2-1).

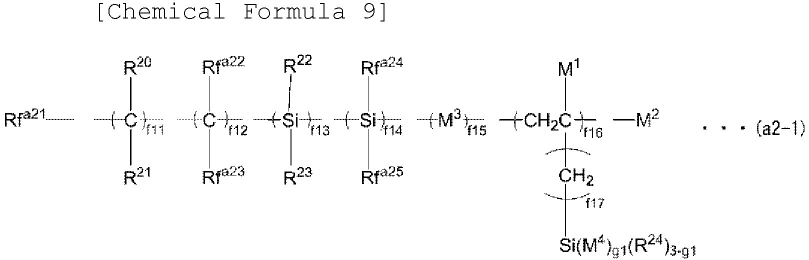

In the formula (a2-1),
Rf^{a21} represents a fluorine atom, or an alkyl group having 1 to 20 carbon atoms in which one or more hydrogen atoms are substituted by a fluorine atom,
Rf^{a22}, Rf^{a23}, Rf^{a24}, and Rf^{a25} each independently represent a fluorine atom, or an alkyl group having 1 to 20 carbon atoms in which one or more hydrogen atoms are substituted by a fluorine atom, when a plurality of Rf^{a22}s are present, the plurality of Rf^{a22}s may be different from each other, when a plurality of Rf^{a23}s are present, the plurality of Rf^{a23}s may be different from each other, when a plurality of Rf^{a24}s are present, the plurality of Rf^{a24}s may be different from each other, and when a plurality of Rf^{a25}s are present, the plurality of Rf^{a25}s may be different from each other,
R²⁰, R²¹, R²², and R²³ each independently represent a hydrogen atom or an alkyl group having 1 to 4 carbon atoms, when a plurality of R²⁰s are present, the plurality of R²⁰s may be different from each other, when a plurality of R²¹s are present, the plurality of R²¹s may be different from each other, when a plurality of R²²s are present, the plurality of R²²s may be different from each other, and when a plurality of R²³s are present, the plurality of R²³s may be different from each other,
R²⁴ represents an alkyl group having 1 to 20 carbon atoms, and when a plurality of R²⁴s are present, the plurality of R²⁴s may be different from each other,
M¹ represents a hydrogen atom or an alkyl group having 1 to 4 carbon atoms, and when a plurality of M¹s are present, the plurality of M¹s may be different from each other,
M² represents a hydrogen atom or a halogen atom,
M³ represents -O-, -C(=O)-O-, -O-C(=O)-, -NR-, - NRC(=O)-, or -C(=O)NR- (R represents a hydrogen atom, an alkyl group having 1 to 4 carbon atoms, or a fluorine-containing alkyl group having 1 to 4 carbon atoms), and when a plurality of M³s are present, the plurality of M³s may be different from each other,
M⁴ represents a hydrolyzable group, and when a plurality of M⁴s are present, the plurality of M⁴s may be different from each other,
f11, f12, f13, f14, and f15 each independently represent an integer of 0 to 600, the total value of f11, f12, f13, f14, and f15 is 13 or more,
f16 represents an integer of 1 to 20,
f17 represents an integer of 0 to 2,
g1 represents an integer of 1 to 3,
Rf^{a21}-; M²-; -{C(R²⁰) (R²¹)}- whose number is f11; - {C(RP²²)(R^{fa23})}- whose number is f12; -{Si(R²²)(R²³)}- whose number is f13, -{Si(Rf^{a24})(Rf^{a25})}- whose number is f14; -M³-whose number is f15; and -[CH₂C(M¹){(CH₂)_{f17}-Si(M⁴)_{g1}(R²⁴)_{3-g1}}]- whose number is f16 are aligned and bonded in any order as long as they are aligned in such an order that Rf^{a21}- and M²- are located at ends and a perfluoropolyether structure is formed in at least a part thereof, and -O-does not link to -O- and -F. That is, in the formula (a2-1), -{C(R²⁰)(R²¹)}- whose number is f11 may not necessarily be continuous, -{C(Rf^{a22})(R^{fa23})}- whose number is f12 may not necessarily be continuous, -{Si (R²²)(R²³)}- whose number is f13 may not necessarily be continuous, -{-Si(Rf^{a24})(Rf^{a25})}- whose number is f14 may not necessarily be continuous, -M³- whose number is f15 may not necessarily be continuous, and - [CH₂C(M¹){(CH₂)_{f17}-Si(M⁴)_{g1}(R²⁴)_{3-g1}}]- whose number is f16 may not necessarily be continuous, and they may not necessarily be aligned in this order, and can be aligned in any order such as -C(R²⁰)(R²¹)-Si(Rf^{a24})(Rf^{a25})-CH₂C(M¹){(CH₂)_{f17}-Si(M⁴)_{g1}(R²⁴)_{3-g1}}-C(Rf^{a22})(R^{fa23})-M³-Si(R²²)(R²³)-C(Rf^{a22})(R^{fa23})-.

Rf^{a21} preferably represents an alkyl group having 1 to 10 carbon atoms substituted by one or more fluorine atoms, more preferably represents a perfluoroalkyl group having 1 to 10 carbon atoms, and still more preferably represents a perfluoroalkyl group having 1 to 5 carbon atoms.

Preferably, Rf^{a22}, Rf^{a23}, Rf^{a24}, and Rf^{a25} each independently represent a fluorine atom, or an alkyl group having 1 to 2 carbon atoms in which one or more hydrogen atoms are substituted by a fluorine atom, and more preferably, all of Rf^{a22}, Rf^{a23}, Rf^{a24}, and Rf^{a25} represent a fluorine atom.

Preferably, R²⁰, R²¹, R²², and R²³ each independently represent a hydrogen atom or an alkyl group having 1 to 2 carbon atoms, and more preferably, all of R²⁰, R²¹, R²², and R²³ represent a hydrogen atom.

R²⁴ preferably represents an alkyl group having 1 to 5 carbon atoms.

Preferably, M¹ each independently represents a hydrogen atom or an alkyl group having 1 to 2 carbon atoms, and more preferably, M¹ each represents a hydrogen atom.

M² preferably represents a hydrogen atom.

Preferably, M³ represents -C(=O)-O-, -O-, -O-C (=O)-, and more preferably, M³ each represents -O-.

M⁴ preferably represents an alkoxy group and a halogen atom, and more preferably represents a methoxy group, an ethoxy group, and a chlorine atom.

f11, f13, and f14 each are preferably 1/2 or less of f12, and more preferably 1/4 or less of f12. f13 or f14 still more preferably represents 0, and particularly preferably represents 0.

f15 is preferably 1/5 or more of the total value of f11, f12, f13, and f14, and is equal to or less than the total value of f11, f12, f13, and f14.

f12 preferably represents 20 to 600, more preferably represents 20 to 200, and still more preferably represents 50 to 200 (yet still more preferably 30 to 150, particularly 50 to 150, and most preferably 80 to 140). f15 preferably represents 4 to 600, more preferably represents 4 to 200, and still more preferably represents 10 to 200 (yet still more preferably 30 to 60). The total value of f11, f12, f13, f14, and f15 preferably represents 20 to 600, more preferably represents 20 to 200, and still more preferably represents 50 to 200.

f16 preferably represents 1 to 18. f16 more preferably represents 1 to 15. f16 still more preferably represents 1 to 10.

f17 preferably represents 0 to 1.

g1 preferably represents 2 to 3, and more preferably represents 3.

-{C(R²⁰)(R²¹)}- whose number is f11; -{C (Rf^{a22})(R^{fa23})}-whose number is f12; -{Si(R²²)(R²³)}- whose number is f13; - {Si(Rf^{a24})(Rf^{a25})}- whose number is f14; and -M³- whose number is f15 may be aligned in any order in the formula as long as the perfluoropolyether structure is formed in at least a part thereof. However, a repeating unit bracketed with f12 (that is, -{C(Rf^{a22})(R^{fa23})}-) on the side closest to the stationary end (side bonded to a silicon atom) is preferably located closer to a free end than a repeating unit bracketed with f11 (that is, -{C(R²⁰)(R²¹)}-) on the side closest to the free end is, and repeating units bracketed with f12 and f14 (that is, -{C(Rf^{a22})(R^{fa23})}- and -{Si(Rf^{a24})(Rf^{a25})}-) on the side closest to the stationary end are more preferably located closer to the free end than repeating units bracketed with f11 and f13 (that is, - {C(R²⁰)(R²¹)}- and -{Si(R²²)(R²³)}-) on the side closest to the free end are.

Preferably, in the formula (a2-1), Rf^{a21} represents a perfluoroalkyl group having 1 to 5 carbon atoms, all of Rf^{a22}, Rf^{a23}, Rf^{a24}, and Rf^{a25} represent a fluorine atom, M³ each represents -O-, M⁴ each represents a methoxy group, an ethoxy group, or a chlorine atom (in particular, a methoxy group or an ethoxy group), M¹ and M² each represent a hydrogen atom, f11 represents 0, f12 represents 30 to 150 (more preferably 80 to 140), f15 represents 30 to 60, f13 and f14 represent 0, f17 represents 0 to 1 (in particular, 0), g1 represents 3, and f16 represents 1 to 10.

The organosilicon compound (A) is also preferably a compound represented by the following formula (a2-2).

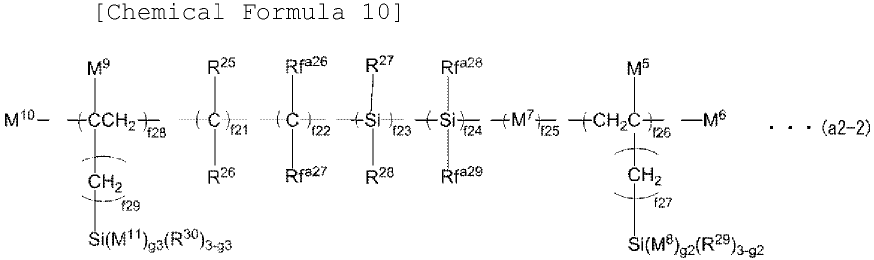

In the formula (a2-2),
Rf^{a26}, Rf^{a27}, Rf^{a28}, and Rf^{a29} each independently represent a fluorine atom, or an alkyl group having 1 to 20 carbon atoms in which one or more hydrogen atoms are substituted by a fluorine atom, when a plurality of Rf^{a26}s are present, the plurality of Rf^{a26}s may be different from each other, when a plurality of Rf^{a27}s are present, the plurality of Rf^{a27}s may be different from each other, when a plurality of Rf^{a28}s are present, the plurality of Rf^{a28}s may be different from each other, and when a plurality of Rf^{a29}s are present, the plurality of Rf^{a29}s may be different from each other,
R²⁵, R²⁶, R²⁷, and R²⁸ each independently represent a hydrogen atom or an alkyl group having 1 to 4 carbon atoms, when a plurality of R²⁵s are present, the plurality of R²⁵s may be different from each other, when a plurality of R²⁶s are present, the plurality of R²⁶s may be different from each other, when a plurality of R²⁷s are present, the plurality of R²⁷s may be different from each other, and when a plurality of R²⁸s are present, the plurality of R²⁸s may be different from each other,
R²⁹ and R³⁰ each independently represent an alkyl group having 1 to 20 carbon atoms, when a plurality of R²⁹s are present, the plurality of R²⁹s may be different from each other, and when a plurality of R³⁰s are present, the plurality of R³⁰s may be different from each other,
M⁷ represents -O-, -C(=O)-O-, -O-C(=O)-, -NR-, - NRC(=O)-, or -C(=O)NR-, R represents a hydrogen atom, an alkyl group having 1 to 4 carbon atoms, or a fluorine-containing alkyl group having 1 to 4 carbon atoms, and when a plurality of M⁷s are present, the plurality of M⁷s may be different from each other,
M⁵ and M⁹ each independently represent a hydrogen atom or an alkyl group having 1 to 4 carbon atoms, when a plurality of M⁵s are present, the plurality of M⁵s may be different from each other, and when a plurality of M⁹s are present, the plurality of M⁹s may be different from each other,
M⁶ and M¹⁰ each independently represent a hydrogen atom or a halogen atom,
M⁸ and M¹¹ each independently represent a hydrolyzable group, when a plurality of M⁸s are present, the plurality of M⁸s may be different from each other, and when a plurality of M¹¹s are present, the plurality of M¹¹s may be different from each other,
f21, f22, f23, f24, and f25 each independently represent an integer of 0 to 600, the total value of f21, f22, f23, f24, and f25 is 13 or more,
f26 and f28 each independently represent an integer of 1 to 20,
f27 and f29 each independently represent an integer of 0 to 2,
g2 and g3 each independently represent an integer of 1 to 3,
M¹⁰-; M⁶-; -{C(R²⁵)(R²⁶)}- whose number is f21; - {C(Rfa²⁶)(Rf^{a27})}- whose number is f22; -{Si(R²⁷)(R²⁸)}- whose number is f23; -{Si(Rf^{a28})(Rf^{a29})}- whose number is f24; -M⁷-whose number is f25; - [CH₂C(M⁵){(CH₂)_{f27}-Si(M⁸)_{g2}(R²⁹)_{3-g2}}] whose number is f26; and - [CH₂C(M⁹){(CH₂)_{f29}-Si(M¹¹)_{g3}(R³⁰)_{3-g3}}] whose number is f28 are aligned and bonded in any order as long as they are aligned in such an order that M¹⁰- and M⁶- are located at ends and the perfluoropolyether structure is formed in at least a part thereof, and -O- is not continuous with **-**O**-.** The alignment and bonding in any order is the same as described for the formula (a2-1), and does not necessarily indicate that the repeating units are continuously aligned in the order as described in the formula (a2-2).

In the formula (a2-2), it is preferable that all of Rf^{a26}, Rf^{a27}, Rf^{a28}, and Rf^{a29} represent a fluorine atom, all of M⁷s represent -O-, all of M^{B}s and M¹¹s represent a methoxy group, an ethoxy group, or a chlorine atom (in particular, a methoxy group or an ethoxy group), M⁵, M⁶, M⁹, and M¹⁰ each represent a hydrogen atom, f21 represents 0, f22 represents 30 to 150 (more preferably 80 to 140), f25 represents 30 to 60, f23 and f24 represent 0, f27 and f29 represent 0 to 1 (particularly preferably 0), g2 and g3 represent 3, and f26 and f28 represent 1 to 10.

More specific examples of the organosilicon compound (A) include a compound represented by the following formula (a3).

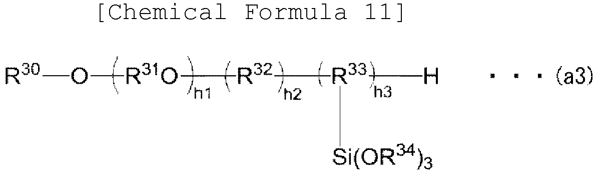

In the formula (a3), R³⁰ represents a perfluoroalkyl group having 2 to 6 carbon atoms, R³¹ and R³² each independently represent a perfluoroalkylene group having 2 to 6 carbon atoms, R³³ represents a trivalent saturated hydrocarbon group having 2 to 6 carbon atoms, and R³⁴ represents an alkyl group having 1 to 3 carbon atoms. Preferably, the numbers of carbon atoms in R³⁰, R³¹, R³², and R³³ each independently represent 2 to 4, and, more preferably, the numbers thereof each independently represent 2 to 3. h1 represents 5 to 70, h2 represents 1 to 5, and h3 represents 1 to 10. h1 preferably represents 10 to 60, and more preferably represents 20 to 50. h2 preferably represents 1 to 4, and more preferably represents 1 to 3. h3 preferably represents 1 to 8, and more preferably represents 1 to 6.

Other examples of the organosilicon compound (A) include a compound represented by the following formula (a4).

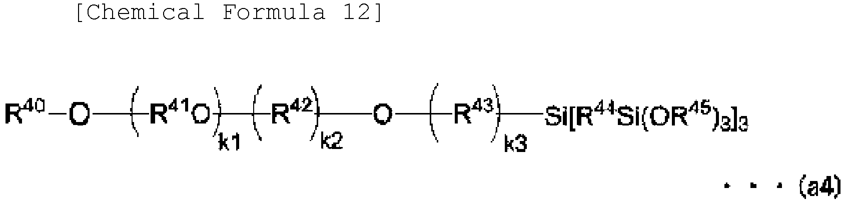

In the formula (a4), R⁴⁰ represents a perfluoroalkyl group having 2 to 5 carbon atoms, R⁴¹ represents a perfluoroalkylene group having 2 to 5 carbon atoms, R⁴² represents a fluoroalkylene group obtained by substituting a part of hydrogen atoms in an alkylene group having 2 to 5 carbon atoms by fluorine, R⁴³ and R⁴⁴ each independently represent an alkylene group having 2 to 5 carbon atoms, and R⁴⁵ represents a methyl group or an ethyl group. k1, k2, and k3 each independently represent an integer of 1 to 5.

The number average molecular weight of the organosilicon compound (A) is preferably 2,000 or more, more preferably 4,000 or more, still more preferably 6,000 or more, and particularly preferably 7,000 or more, and is preferably 40,000 or less, more preferably 20,000 or less, and still more preferably 15,000 or less.

Examples of the organosilicon compound (A) include a compound represented by the following formula (1) or a compound having a structure similar to that of the compound, and include OPTOOL (registered trademark) UF503 manufactured by DAIKIN INDUSTRIES, LTD.

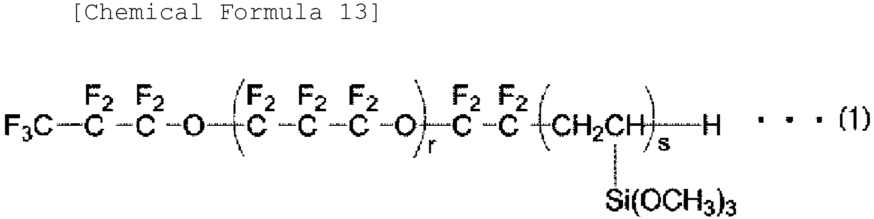

Examples of the compound represented by the formula (1) include a compound synthesized by methods described in Synthesis Examples 1 and 2 in JP 2014-15609 A. r represents 43, s represents an integer of 1 to 6, and the number average molecular weight is about 8000.

Examples of the similar structure include a structure in which the number of carbon atoms in the hydrocarbon group or the number of carbon atoms in the hydrocarbon groups substituted by fluorine atoms is different from that in the formula (1), a structure in which a perfluoropolyether structure and a silicon atom are bonded without a linking group interposed therebetween, a structure in which another hydrocarbon group (also including a hydrocarbon group in which at least a part of hydrogen atoms is substituted by a fluorine atom) is interposed at any position in a linking group between a perfluoropolyether structure and a silicon atom, a structure in which a silicon atom and a hydrolyzable group are bonded with a linking group interposed therebetween, and a structure in which values of r and s are different, but are not limited to these structures.

The organosilicon compound (A) is preferably a compound represented by the formula (a1), more preferably a compound represented by the formula (a2-1), and still more preferably a compound represented by the formula (a3).

As the organosilicon compound (A), only one kind may be used, or two or more kinds may be used.

### <Organosilicon Compound (B)>

The organosilicon compound (B) is a compound represented by the following formula (b1).

The organosilicon compound (B) represented by the following formula (b1) has a hydrolyzable group represented by A² as described later, and usually a -SiOH group of the organosilicon compound (B) generated by hydrolysis is dehydration-condensed with a -SiOH group of the organosilicon compound (A) generated by hydrolysis and/or a -SiOH group of the organosilicon compound (B) generated by hydrolysis. Therefore, in a preferable aspect, the water-repellent layer (r) which is a cured layer of the mixed composition (ca) has a condensed structure derived from the organosilicon compound (A) and a condensed structure derived from the organosilicon compound (B). Examples of the hydrolyzable group include an alkoxy group, a halogen atom, a cyano group, an acetoxy group, and an isocyanate group.

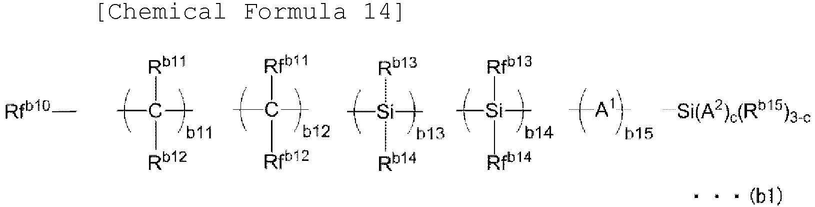

In the formula (b1),
Rf^{b10} represents a fluorine atom, or an alkyl group having 1 to 20 carbon atoms in which one or more hydrogen atoms are substituted by a fluorine atom,
R^{b11}, R^{b12}, R^{b13}, and R^{b14} each independently represent a hydrogen atom or an alkyl group having 1 to 4 carbon atoms, when a plurality of R^{b11}s are present, the plurality of R^{b11}s may be different from each other, when a plurality of R^{b12}s are present, the plurality of R^{b12}s may be different from each other, when a plurality of R^{b13}s are present, the plurality of R^{b13}s may be different from each other, and when a plurality of R^{b14}s are present, the plurality of R^{b14}s may be different from each other,
Rf^{b11}, Rf^{b12}, Rf^{b13}, and Rf^{b14} each independently represent a fluorine atom, or an alkyl group having 1 to 20 carbon atoms in which one or more hydrogen atoms are substituted by a fluorine atom, when a plurality of Rf^{b11}s are present, the plurality of Rf^{b11}s may be different from each other, when a plurality of Rf^{b12}s are present, the plurality of Rf^{b12}s may be different from each other, when a plurality of Rf^{b13}s are present, the plurality of Rf^{b13}s may be different from each other, and when a plurality of Rf^{b14}s are present, the plurality of Rf^{b14}s may be different from each other,
R^{b15} represents an alkyl group having 1 to 20 carbon atoms, when a plurality of R^{b15}s are present, the plurality of R^{b15}s may be different from each other,
A¹ represents -O-, -C(=O)-O-, -O-C(=O)-, -NR-, - NRC(=O)-, or -C(=O)NR-, the R represents a hydrogen atom, an alkyl group having 1 to 4 carbon atoms, or a fluorine-containing alkyl group having 1 to 4 carbon atoms, when a plurality of A¹s are present, the plurality of A¹s may be different from each other,
A² is a hydrolyzable group, and when a plurality of A²s are present, the plurality of A²s may be different from each other,
b11, b12, b13, b14, and b15 each independently represent an integer of 0 to 100,
c represents an integer of 1 to 3, and
Rf^{b10}-; -Si(A²)_{c}(R^{b15})_{3-c}; -{C(R^{b11})(R^{b12})}- whose number is b11; -{C(Rf^{b11}) (Rf^{b12})}- whose number is b12; - {Si(R^{b13})(R^{b14})}- whose number is b13; -{Si(Rf^{b13})(Rf^{b14)}}-whose number is b14; and -A¹- whose number is b15 are aligned and bonded in any order as long as Rf^{b10}- and - Si(A²)_{c}(R^{b15})_{3-c} are located at ends, no perfluoropolyether structure is formed, and -O- does not link to -O- and -F.

Rf^{b10} each independently represents a fluorine atom or a perfluoroalkyl group having 1 to 10 (more preferably 1 to 5) carbon atoms.

R^{b11}, R^{b12}, R^{b13}, and R^{b14} preferably represent a hydrogen atom.

R^{b15} preferably represents an alkyl group having 1 to 5 carbon atoms.

A¹ preferably represents -O-, -C (=O)-O-, or -O-C (=O)-.

A² preferably represents an alkoxy group having 1 to 4 carbon atoms or a halogen atom, and more preferably represents a methoxy group, an ethoxy group, or a chlorine atom.

b11 preferably represents 1 to 30, more preferably represents 1 to 25, still more preferably represents 1 to 10, particularly preferably represents 1 to 5, and most preferably 1 to 2.

b12 preferably represents 0 to 15, and more preferably represents 0 to 10.

b13 preferably represents 0 to 5, and more preferably represents 0 to 2.

b14 preferably represents 0 to 4, and more preferably represents 0 to 2.

b15 preferably represents 0 to 4, and more preferably represents 0 to 2.

c preferably represents 2 to 3, and more preferably represents 3.

The total value of b11, b12, b13, b14, and b15 is preferably 3 or more, preferably 5 or more, and preferably 80 or less, more preferably 50 or less, still more preferably 20 or less.

In particular, it is preferable that Rf^{b10} represents a fluorine atom or a perfluoroalkyl group having 1 to 5 carbon atoms, R^{b11} and R^{b12} each represent a hydrogen atom, A² represents a methoxy group or an ethoxy group, b11 represents 1 to 5, b12 represents 0 to 5, all of b13, b14, and b15 represent 0, and c represents 3.

When FAS13E used as the compound (B) in Examples described below is represented by the formula (b1), R^{b11} and R^{b12} each represent a hydrogen atom, b11 represents 2, all of b13, b14, and b15 represent 0, c represents 3, A² represents an ethoxy group, Rf^{b10}-{C(Rf^{b11})(Rf^{b12})}_{b12}- is located at end and represents C₆F₁₃-.

Specific examples of a compound represented by the formula (b1) include CF₃-Si-(OCH₃)₃ and CⱼF₂ⱼ₊₁-Si-(OC₂H₅)₃ (j represents an integer of 1 to 12). Among them, in particular, C₄F₉-Si-(OC₂H₅)₃, C₆F₁₃-Si-(OC₂H₅)₃, C₇F₁₅-Si-(OC₂H₅)₃, and C₈F₁₇-Si-(OC₂H₅)₃ are preferable. Further, the specific examples include CF₃CH₂O (CH₂)ₖSiCl₃, CF₃CH₂O (CH₂)ₖSi (OCH₃)₃, CF₃CH₂O (CH₂)ₖSi(OC₂H₅)₃, CF₃(CH₂)₂Si(CH₃)₂(CH₂)ₖSiCl₃, CF₃(CH₂)₂Si(CH₃)₂(CH₂)ₖSi(OCH₃)₃, CF₃(CH₂)₂Si(CH₃)₂(CH₂)ₖSi(OC₂H₅)₃, CF₃(CH₂)₆Si(CH₃)₂(CH₂)ₖSiCl₃, CF₃(CH₂)₆Si(CH₃)₂(CH₂)ₖSi(OCH₃)₃, CF₃(CH₂)₆Si(CH₃)₂(CH₂)ₖSi(OC₂H₅)₃, CF₃COO(CH₂)ₖSiCl₃, CF₃COO(CH₂)ₖSi(OCH₃)₃, and CF₃COO(CH₂)ₖSi(OC₂H₅)₃ (k each represents 5 to 20, and preferably represents 8 to 15). The specific examples also include CF₃(CF₂)ₘ-(CH₂)ₙSiCl₃, CF₃(CF₂)ₘ-(CH₂)ₙSi(OCH₃)₃, and CF₃(CF₂)ₘ-(CH₂)ₙSi(OC₂H₅)₃ (m each represents 1 to 10, and preferably represents 3 to 7, n each represents 1 to 5, and more preferably represents 2 to 4). The specific examples also include CF₃(CF₂)ₚ-(CH₂)_{q}-Si-(CH₂CH=CH₂)₃ (p represents 2 to 10, and preferably represents 2 to 8, q represents 1 to 5, and preferably represents 2 to 4). Further, the specific examples include CF₃(CF₂)ₚ-(CH₂)_{q}SiCH₃Cl₂, CF₃(CF₂)ₚ-(CH₂)_{q}SiCH₃(OCH₃)₂, and CF₃(CF₂)ₚ-(CH₂)_{q}SiCH₃(OC₂H₅)₂ (p each represents 2 to 10, and more preferably represents 3 to 7, q each represents 1 to 5, and more preferably represent 2 to 4).

The organosilicon compound (B) is preferably a compound represented by the following formula (b2).
[Chemical Formula 15]

**R⁶⁰-R⁶¹-Si(OR⁶²)₃** · · · (b2)

In the formula (b2), R⁶⁰ represents a perfluoroalkyl group having 3 to 8 carbon atoms, R⁶¹ represents an alkylene group having 1 to 5 carbon atoms, and R⁶² represents an alkyl group having 1 to 3 carbon atoms.

As the organosilicon compound (B), only one kind may be used, or two or more kinds may be used.

The mixed composition (ca) is a composition in which the organosilicon compound (A) is mixed, and preferably a composition in which the organosilicon compound (A) and the organosilicon compound (B) are mixed. The mixed composition (ca) is obtained by mixing the organosilicon compound (A) and the organosilicon compound (B) as necessary. When a component other than the organosilicon compound (A) and the organosilicon compound (B) is mixed, the mixed composition (ca) is obtained by mixing the organosilicon compound (A), the organosilicon compound (B) as necessary, and the other component. The mixed composition (ca) also includes a composition in which a reaction has been proceeded after mixing, for example, during storage.

### <Solvent (D)>

The mixed composition (ca) preferably contains a solvent (D).

As the solvent (D), a fluorine-based solvent is preferably used, and for example, a fluorinated ether-based solvent, a fluorinated amine-based solvent, and a fluorinated hydrocarbon-based solvent and the like can be used. A solvent having a boiling point of 100°C or higher is particularly preferable. As the fluorinated ether-based solvent, hydrofluoroethers such as fluoroalkyl (in particular, a perfluoroalkyl group having 2 to 6 carbon atoms)-alkyl (in particular, a methyl group or an ethyl group) ether are preferable, and examples thereof include ethyl nonafluorobutyl ether and ethyl nonafluoroisobutyl ether. Examples of the ethyl nonafluorobutyl ether or ethyl nonafluoroisobutyl ether include Novec (registered trademark) 7200 (manufactured by 3M, molecular weight: about 264). As the fluorinated amine-based solvent, an amine in which at least one hydrogen atom in ammonia is substituted by a fluoroalkyl group is preferable. A tertiary amine in which all hydrogen atoms in ammonia are substituted by fluoroalkyl groups (in particular, perfluoroalkyl groups) is preferable. Specific examples of the fluorinated amine-based solvent include tris(heptafluoropropyl)amine, and Fluorinert (registered trademark) FC-3283 (manufactured by 3M, molecular weight: about 521) corresponds thereto. Examples of the fluorinated hydrocarbon-based solvent include fluorinated aliphatic hydrocarbon-based solvents such as 1,1,1,3,3-pentafluorobutane, and fluorinated aromatic hydrocarbon-based solvents such as 1,3-bis(trifluoromethyl benzene). Examples of 1,1,1,3,3-pentafluorobutane include SOLVE 55 (manufactured by SOLVEX Co., Ltd.).

As the fluorine-based solvent, in addition to the above, a hydrochlorofluorocarbon such as ASAHIKLIN (registered trademark) AK225 (manufactured by AGC Inc.), and a hydrofluorocarbon such as ASAHIKLIN (registered trademark) AC2000 (manufactured by AGC Inc.), and the like can be used.

As the solvent (D), at least a fluorinated amine-based solvent is preferably used. As the solvent (D), two or more kinds of fluorine-based solvents are preferably used, and the fluorinated amine-based solvent and the fluorinated hydrocarbon-based solvent (in particular, fluorinated aliphatic hydrocarbon-based solvent) are preferably used.

### <Other Components>

In the mixed composition (ca), various additives such as a silanol condensation catalyst, an antioxidant, a rust inhibitor, an ultraviolet absorber, a light stabilizer, an antifungal agent, an antibacterial agent, a biofouling inhibitor, a deodorant, a pigment, a flame retardant, and an antistatic agent may be mixed as long as the effect of the present disclosure is not impaired.

The content of the organosilicon compound (A) in the mixed composition (ca) is, for example, 0.05 mass% or more, preferably 0.1 mass% or more, and more preferably 0.2 mass% or more, and preferably 1.0 mass% or less, more preferably 0.8 mass% or less, and still more preferably 0.6 mass% or less, with respect to 100 mass% of the whole of the mixed composition (ca).

The content of the organosilicon compound (B) in the mixed composition (ca) is, for example, 0.01 mass% or more, and preferably 0.03 mass% or more, and preferably 0.3 mass% or less, and more preferably 0.2 mass% or less, with respect to 100 mass% of the whole of the mixed composition (ca).

The mass ratio of the content of the organosilicon compound (B) to the content of the organosilicon compound (A) is preferably 0.05 or more, more preferably 0.08 or more, and still more preferably 0.10 or more, and preferably 2.0 or less, more preferably 1.0 or less, and still more preferably 0.6 or less.

The amounts of the organosilicon compounds (A) and (B) can be adjusted when the composition is prepared. The amounts of the organosilicon compounds (A) and (B) may be calculated from the analysis result of the composition.

### [Procedure of Step 2]

Step 2 is a step of forming a water-repellent layer (r) on the intermediate layer (c) obtained in step 1. As described above, the water-repellent layer (r) is a cured layer of the mixed composition (ca).

A method for forming the cured layer is not particularly limited, and examples thereof include a method in which the mixed composition (ca) is applied onto the intermediate layer (c) obtained in step 1, and then the applied mixed composition (ca) is subjected to a curing treatment.

The mixed composition (ca) can be prepared, for example, by mixing respective components.

The order and/or timing of mixing the respective components is not particularly limited, and examples thereof include a method in which the organosilicon compound (A) and optional components as necessary are sequentially added to a container, followed by stirring and mixing. When the respective components are added to the container, the components may be added at once, or may be added in a plurality of times in a divided manner.

The stirring may be performed using a known stirring device, and examples thereof include a mechanical stirrer, a magnetic stirrer, a homogenizer, and an ultrasonic disperser.

Examples of a method for applying the mixed composition (ca) to the intermediate layer (c) include a dip coating method, a roll coating method, a bar coating method, a spin coating method, a spray coating method, a die coating method, and a gravure coating method.

The method for applying the mixed composition (ca) is preferably a dip coating method from the viewpoint of productivity.

An immersion time in the dip coating method may be appropriately adjusted depending on the mixed composition (ca) and the substrate, but is preferably 1 to 180 seconds, and more preferably 5 to 60 seconds. A pulling-up speed in the dip coating method may also be appropriately adjusted depending on the mixed composition (ca) and the substrate, but is preferably 1.0 to 10.0 mm/s, and more preferably 2.0 to 6.0 mm/s.

Examples of a method for curing the mixed composition (ca) applied onto the intermediate layer (c) include drying and thermal curing.

The curing method may be appropriately selected depending on the composition of the mixed composition (ca), and for example, the water-repellent layer (r) can be formed by curing the mixed composition (ca) applied onto the intermediate layer (c) by wet heating.

A curing temperature is preferably 5°C or higher, more preferably 10°C or higher, and still more preferably 15°C or higher, and preferably 100°C or lower, more preferably 80°C or lower, and still more preferably 60°C or lower.

Curing moisture is preferably 30% RH or higher, more preferably 50% RH or higher, and still more preferably 60% RH or higher, and preferably 90% RH or lower, and more preferably 85% RH or lower.

A curing time is preferably 5 minutes or more, more preferably 10 minutes or more, and still more preferably 20 minutes or more, and is preferably 24 hours or less, more preferably 12 hours or less, still more preferably 6 hours or less, and particularly preferably 1 hour or less.

### [Water-Repellent Layer (r)]

The water-repellent layer (r) is a cured layer of the mixed composition (ca) of the organosilicon compound (A).

As described above, for example, the water-repellent layer (r) is obtained by applying and curing the mixed composition (ca), and has a structure derived from the organosilicon compound (A). The organosilicon compound (A) has a hydrolyzable group bonded to a silicon atom (may be bonded with a linking group interposed therebetween), and - SiOH groups (Si and OH may be bonded with a linking group interposed therebetween) of the organosilicon compound (A) generated by hydrolysis dehydrate and condense with each other, so that the water-repellent layer (r) usually has a condensed structure derived from the organosilicon compound (A).

The thickness of the water-repellent layer (r) is, for example, 1 to 1000 nm.

### [Step 3]

The present producing method preferably includes step 3 of subjecting the antireflection layer of the substrate (s) including the antireflection layer to a hydrophilization treatment before step 1.

Examples of the hydrophilization treatment include hydrophilization treatments such as a corona treatment, a plasma treatment, an ultraviolet treatment, and an ion cleaning treatment, and a plasma treatment and an ion cleaning treatment are more preferable. By performing the hydrophilization treatment such as a plasma treatment, a functional group such as an OH group or a COOH group can be formed on the surface of the antireflection layer. When such a functional group is formed on the surface of the antireflection layer, particularly, the adhesion between the intermediate layer (c) and the substrate (s) including the antireflection layer can be further improved. Therefore, when step 3 is performed, step 1 is preferably a step of vapor-depositing the organosilicon compound (C) on the surface subjected to the hydrophilization treatment. However, when the laminate is used for a spectacle lens, it is preferable to vapor-deposit the organosilicon compound (C) without subjecting the antireflection layer of the substrate (s) to a hydrophilization treatment. Therefore, the hydrophilization treatment is preferably performed when the laminate is used for applications other than spectacle lenses.

### [Production of Spectacle Lens]

The present producing method can be suitably used in the producing step of a spectacle lens.

The present producing method may be carried out in combination with or after other steps performed on the laminate for the production of the spectacle lens. Examples of the other steps include a lens edging processing step, a dyeing step, a shape processing step, and an inspecting step of the laminate.

The laminate may be used as it is as the spectacle lens.

### [Laminate]

The laminate produced by the present producing method will be described.

### [Configuration of Laminate]

The laminate includes a substrate (s) including an antireflection layer, an intermediate layer (c) formed on the antireflection layer by vapor deposition, and a water-repellent layer (r) formed on the intermediate layer.

The laminate may include other members as long as the effects of the present disclosure are not impaired. Examples of the other member include a primer layer, a hard coat layer, a protective film, and a hydrophobic resin film.

### [Physical Properties of Laminate]

In the laminate, the contact angle and sliding angle of water measured on a surface subjected to an abrasion resistance test after the abrasion resistance test described later is performed on the surface on the water-repellent layer (r) side preferably satisfy at least one of the following requirements (1) and (2), and more preferably satisfy both the requirements (1) and (2).
(1) The contact angle of water is 110° or more.
(2) The sliding angle of water is 10° or less.

The contact angle is also preferably 115° or more, and may be 130° or less.

The sliding angle may be 0.5° or more.

The abrasion resistance test is a test in which a load of 200 g per area of 1.5 cm × 1.5 cm is applied to the surface of the laminate on the water-repellent layer (r) side, and the laminate is rubbed 20,000 times. The laminate is preferably rubbed with paper made of a pulp material, and more preferably rubbed with paper made of a pulp material and attached to an elastic body. As the paper made of a pulp material, it is preferable to use KimWipe S-200 manufactured by Nippon Paper Crecia Co., Ltd. For example, the contact angle and the sliding angle are preferably measured at substantially the center of a stroke region using KimWipe S-200 with a stroke distance in the abrasion resistance test set to 30 mm and a rubbing speed set to 70 to 90 reciprocations/minute. When the load is applied, the load may be a pressure equivalent to applying a load of 200 g per area of 1.5 cm × 1.5 cm. The laminate including the water-repellent layer (r) having a size of less than 1.5 cm × 1.5 cm is also included in the scope of the present disclosure.

### [Application of Laminate]

The laminate can be applied to various applications.

When a substrate for spectacle lenses is used as the substrate, the substrate for spectacle lenses can be suitably used as a spectacle lens.

The laminate can be preferably used as a front plate in a flexible display device, and the front plate may be referred to as a window film. The flexible display device preferably includes a laminate for a flexible display device and an organic EL display panel, and the laminate for the flexible display device is disposed on the viewing side with respect to the organic EL display panel, and is foldable. The laminate for the flexible display device may further include a polarizing plate (preferably a circularly polarizing plate) and a touch sensor and the like. These are laminated in any order, and it is preferable that the window film (that is, the laminate obtained by the present producing method), the polarizing plate, and the touch sensor are laminated in this order from the viewing side, or the window film, the touch sensor, and the polarizing plate are laminated in this order from the viewing side. The polarizing plate is preferably disposed closer to the viewing side than the touch sensor is, because the pattern of the touch sensor is less likely to be viewed and the visibility of a display image is improved. The members can be laminated by using an adhesive or a pressure-sensitive adhesive or the like. The flexible display device can include a light shielding pattern formed on at least one surface of any layer of the window film, the polarizing plate, and the touch sensor.

### EXAMPLES

Hereinafter, the present disclosure will be specifically described with reference to Examples. The present disclosure is not limited by the following Examples, and it is of course possible to carry out the present disclosure with appropriate modifications within a range that can be adapted to the gist, and any of these modifications are included in the technical scope of the present disclosure.

### [Examples 1 to 4 and Comparative Example 1 to 2]

### [Preparation of Laminate]

### <Preparation of Substrate (s) Including Antireflection Layer>

A coating liquid was applied to the surface of NL3-SP (size: 75mmφ, center thickness: 1.1 mm) manufactured by Nikon-Essilor Co., Ltd. by an immersion method, and cured by heating to laminate a urethane-based impact resistance-improving coat (primer layer) having a thickness of about 1 µm and a silicone-based scratch resistance-improving hard coat (hard coat layer) having a thickness of about 2 µm in this order.

Next, on the hard coat layer, an antireflection coat (corresponding to an antireflection layer (ar), a layer formed by alternately laminating a silica layer and a zirconia layer) which was a multilayer film made of an inorganic oxide (silica and zirconia) and having a thickness of about 0.4 µm was formed by a vacuum vapor deposition method, to obtain a substrate (s) including an antireflection layer.

### <Step 1>

As an organosilicon compound (C), a reaction product of N-2-(aminoethyl)-3-aminopropyltrimethoxysilane and chloropropyltrimethoxysilane (product name; X-12-5263HP, manufactured by Shin-Etsu Chemical Co., Ltd.) described in JP 2012-197330 A and represented by the following formula was used.

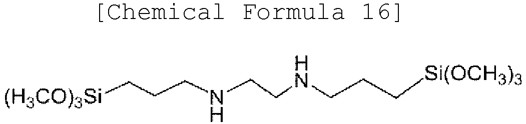

Using a vacuum deposition apparatus (model No. 1200-DLX-2 manufactured by Satisloh), the output of an electron beam was set so that an average vapor deposition rate was a value shown in Table 1, and the organosilicon compound (C) was vapor-deposited on the antireflection layer of the substrate (s) including the antireflection layer at a degree of vacuum of 1.0×10⁻² Pa to form an intermediate layer (c) having a thickness of 15 to 35 nm.

The average vapor deposition rate is a value (average vapor deposition rate (nm/s) = film thickness (nm)/vapor deposition time (s)) obtained by dividing the film thickness of a vapor-deposited film by a vapor deposition time required to form the vapor-deposited film having the above film thickness.

The film thickness was measured with a quartz oscillator type film thickness meter in which a calibration value was set so as to indicate the film thickness on the substrate.

### <Step 2>

A solution in which OPTOOL (registered trademark) UF503 manufactured by DAIKIN INDUSTRIES, LTD. as an organosilicon compound (A), FAS13E (C₆F₁₃-C₂H₄-Si (OC₂H₅)₃, manufactured by Tokyo Chemical Industry Co., Ltd.) as an organosilicon compound (B), and FC-3283 (C₉F₂₁N, Fluorinert, manufactured by 3M) as a solvent (D) were mixed, was prepared and stirred at a room temperature for a predetermined time, to obtain a mixed composition (ca).

In the mixed composition (ca), the ratio of the organosilicon compound (A) was 0.425 mass% and the ratio of the organosilicon compound (B) was 0.05 mass% when the entire mixed composition (ca) was 100 mass%.

The mixed composition (ca) was applied onto the intermediate layer (c) formed in step 1 described above using a dip coater (DT-0001-S3 manufactured by SDI Corporation) under the conditions of an immersion time of 10 seconds and a pulling-up speed of 3.5 mm/sec. Thereafter, moist-heat curing was performed at 50°C and 80% RH for 30 minutes to form a water-repellent layer (r) as a cured layer of the mixed composition (ca).

### [Evaluation]

The laminates obtained in Examples and Comparative Examples were evaluated by the following methods.

Using 16 laminated Kimwipe Wiper S-200 manufactured by Nippon Paper Crecia Co., Ltd. and attached to a 15 mm × 15 mm square elastic body (plastic eraser, Type 1156SMTR00 manufactured by Maped (France)), a 200 g load was applied to the water-repellent layer (r) of the laminate, and the water-repellent layer (r) was rubbed 20000 times at a 30 mm stroke and 90 r/minute (90 reciprocations per one minute) to perform an abrasion resistance test.

Thereafter, the contact angle of water and the sliding angle of water after the abrasion resistance test were measured at almost the center of the abraded portion by the following method.

Water droplet was dropped by 1 µL onto the water-repellent layer (r) of the obtained laminate, and the contact angle of water was measured by a droplet method (analysis method: elliptic fitting method) using a contact angle measuring device (DM-500/DM-SA manufactured by Kyowa Interface Science Co., Ltd.).

Water droplet was dropped by 20 µL onto the water-repellent layer (r) of the obtained laminate, and the sliding angle of water was measured by a sliding method (analysis method: perfect circle fitting method, inclination method: continuous inclination, sliding detection: before sliding, movement determination: advancing and receding, sliding determination distance: 10 dots) using a contact angle measuring device (DM-500/DM-SA manufactured by Kyowa Interface Science Co., Ltd.).

For the laminates prepared under the respective conditions described in Examples 1 to 4 and Comparative Examples 1 and 2, the contact angle of water and the sliding angle of water after the abrasion resistance test were measured for 3 samples in each of Examples and Comparative Examples. After the abrasion resistance test, a sample in which the laminate satisfied all of the following requirements (1) and (2) was determined as a good product having excellent abrasion resistance, and a sample in which the laminate did not satisfy at least one of the requirements was determined as a defective product.
(1) The sliding angle of water after the abrasion resistance test is 10° or less.
(2) The contact angle of water after the abrasion resistance test is 110° or more.

A good product rate was calculated with the ratio of good products among the three samples evaluated as the good product rate (good product rate (%) = the number of good product samples/the number of measured samples × 100).

As the good product rate is higher, the abrasion resistance is higher, and the productivity of the laminate is higher.

### [Results]

The results of Examples 1 to 4 and Comparative Examples 1 to 2 are shown in Table 1.

**[Table 1]**

| Table 1 | Example 1 | Example 2 | Example 3 | Example 4 | Comparative Example 1 | Comparative Example 2 |
|---|---|---|---|---|---|---|
| Average vapor deposition rate [nm/s] | 0.20 | 0.40 | 0.60 | 1.09 | 0.12 | 1.22 |
| Good product rate | 100% | 100% | 100% | 100% | 67% | 33% |

As shown in Table 1, the method for producing a laminate of the present disclosure was confirmed to be able to produce a laminate excellent in abrasion resistance with high productivity.

## Claims

1. A method for producing a laminate, the method comprising:
step 1 of forming an intermediate layer (c) on an antireflection layer of a substrate (s) including the antireflection layer by vapor deposition; and
step 2 of forming a water-repellent layer (r) on the intermediate layer (c), wherein
the intermediate layer (c) is a vapor-deposited layer of an organosilicon compound (C) having a silicon atom and having an amino group and/or an amine skeleton,
the water-repellent layer (r) is a cured layer of a mixed composition (ca) of an organosilicon compound (A) in which a monovalent group having a perfluoropolyether structure is bonded to a silicon atom with a linking group interposed therebetween or without a linking group interposed therebetween, and a hydrolyzable group is bonded to the silicon atom with a linking group interposed therebetween or without a linking group interposed therebetween, and
an average vapor deposition rate when the intermediate layer (c) is formed is 0.2 nm/s or more and less than 1.2 nm/s.

2. The method for producing a laminate according to claim 1, wherein
the organosilicon compound (A) is at least one organosilicon compound represented by the following formula (a1): 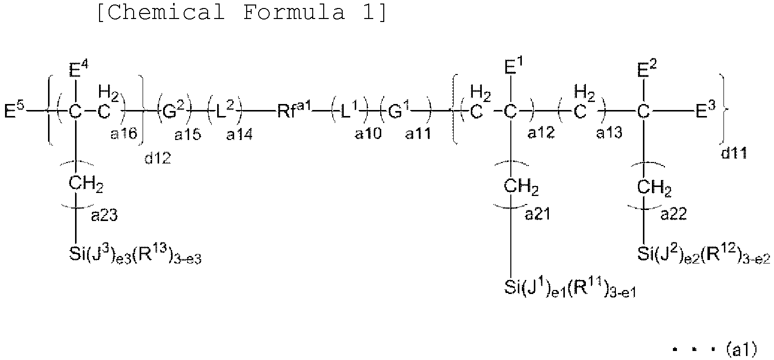
wherein, in formula (a1),
Rf^{a1} represents a divalent perfluoropolyether structure having oxygen atoms at both ends,
R¹¹, R¹², and R¹³ each independently represent an alkyl group having 1 to 20 carbon atoms, when a plurality of R¹¹s are present, the plurality of R¹¹s may be different from each other, when a plurality of R¹²s are present, the plurality of R¹²s may be different from each other, and when a plurality of R¹³s are present, the plurality of R ¹³s may be different from each other,
E¹, E², E³, E⁴, and E⁵ each independently represent a hydrogen atom or a fluorine atom, when a plurality of E¹s are present, the plurality of E¹s may be different from each other, when a plurality of E²s are present, the plurality of E²s may be different from each other, when a plurality of E³s are present, the plurality of E³s may be different from each other, and when a plurality of E⁴s are present, the plurality of E⁴s may be different from each other,
G¹ and G² each independently represent a divalent to decavalent organosiloxane group having a siloxane bond,
J¹, J², and J³ each independently represent a hydrolyzable group or -(CH₂)ₑ₆-Si(OR¹⁴)₃, e6 represents 1 to 5, R¹⁴ represents a methyl group or an ethyl group, when a plurality of J¹s are present, the plurality of J¹s may be different from each other, when a plurality of J²s are present, the plurality of J²s may be different from each other, and when a plurality of J³s are present, the plurality of J³s may be different from each other,
L¹ and L² each independently represent a divalent linking group having 1 to 12 carbon atoms, which may contain an oxygen atom, a nitrogen atom, or a fluorine atom, when a plurality of L¹s are present, the plurality of L¹s may be different from each other, and when a plurality of L²s are present, the plurality of L²s may be different from each other,
d11 represents 1 to 9,
d12 represents 0 to 9,
a10 and a14 each independently represent 0 to 10,
a11 and a15 each independently represent 0 or 1,
a12 and a16 each independently represent 0 to 9,
a13 represents 0 or 1,
a21, a22, and a23 each independently represent 0 to 2, and
e1, e2, and e3 each independently represent 1 to 3.

3. The method for producing a laminate according to claim 1 or 2, wherein
the mixed composition (ca) further contains at least one organosilicon compound (B) represented by the following formula (b1): 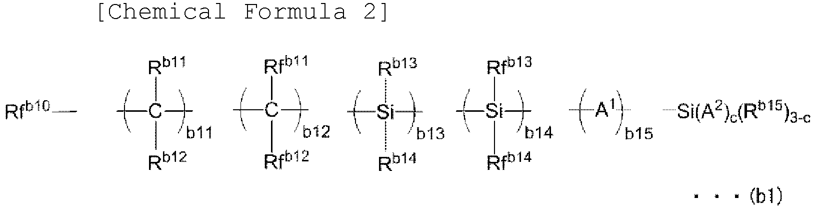
wherein, in formula (b1), Rf^{b10} is a fluorine atom, or an alkyl group having 1 to 20 carbon atoms in which one or more hydrogen atoms are substituted by a fluorine atom,
R^{b11}, R^{b12}, R^{b13}, and R^{b14} each independently represent a hydrogen atom or an alkyl group having 1 to 4 carbon atoms, when a plurality of R^{b11}s are present, the plurality of R^{b11}s may be different from each other, when a plurality of R^{b12}s are present, the plurality of R^{b12}s may be different from each other, when a plurality of R^{b13}s are present, the plurality of R^{b13}s may be different from each other, and when a plurality of R^{b14}s are present, the plurality of R^{b14}s may be different from each other,
Rf^{b11}, Rf^{b12}, Rf^{b13}, and Rf^{b14} each independently represent a fluorine atom, or an alkyl group having 1 to 20 carbon atoms in which one or more hydrogen atoms are substituted by a fluorine atom, when a plurality of Rf^{b11}s are present, the plurality of Rf^{b11}s may be different from each other, when a plurality of Rf^{b12}s are present, the plurality of Rf^{b12}s may be different from each other, when a plurality of Rf^{b13}s are present, the plurality of Rf^{b13}s may be different from each other, and when a plurality of Rf^{b14}s are present, the plurality of Rf^{b14}s may be different from each other,
R^{b15} represents an alkyl group having 1 to 20 carbon atoms, when a plurality of R^{b15}s are present, the plurality of R^{b15}s may be different from each other,
A¹ is -O-, -C(=O)-O-, -O-C(=O)-, -NR-, -NRC(=O)-, or -C(=O)NR-, the R represents a hydrogen atom, an alkyl group having 1 to 4 carbon atoms, or a fluorine-containing alkyl group having 1 to 4 carbon atoms, and when a plurality of A¹s are present, the plurality of A¹s may be different from each other,
A² represents a hydrolyzable group, when a plurality of A²s are present, the plurality of A²s may be different from each other,
b11, b12, b13, b14, and b15 each independently represent an integer of 0 to 100,
c represents an integer of 1 to 3, and
Rf^{b10}-; -Si(A²)_{c}(R^{b15})_{3-c}; -{C(R^{b11})(R^{b12})}- whose number is b11; -{C(Rf^{b11})(Rf^{b12})}- whose number is b12; - {Si(R^{b13})(R^{b14})}- whose number is b13; -{Si(Rf^{b13})(Rf^{b14})}-whose number is b14; and -A¹- whose number is b15 are aligned and bonded in any order as long as Rf^{b10}- and - Si(A²)_{c}(R^{b15})_{3-c} are located at ends, no perfluoropolyether structure is formed, and -O- does not link to -O- and -F.

4. The method for producing a laminate according to claim 3, wherein a mass ratio of the organosilicon compound (B) to the organosilicon compound (A) in the mixed composition (ca) is 0.05 to 2.0.

5. The method for producing a laminate according to any one of claims 1 to 4, wherein a hydrolyzable group or a hydroxy group is bonded to at least one silicon atom in the organosilicon compound (C).

6. The method for producing a laminate according to any one of claims 1 to 5, wherein
the organosilicon compound (C) is an organosilicon compound represented by the following formula (c2): 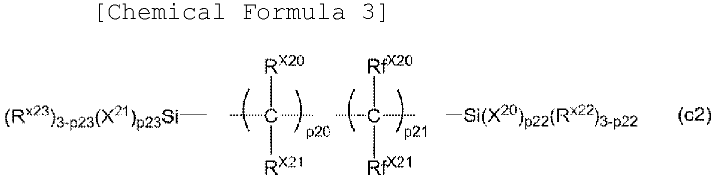
wherein, in formula (c2),
R^{x20} and R^{x21} each independently represent a hydrogen atom or an alkyl group having 1 to 4 carbon atoms, when a plurality of R^{x20}s are present, the plurality of R^{x20}s may be different from each other, and when a plurality of R^{×21}s are present, the plurality of R^{x21}s may be different from each other,
Rf^{x20} and Rf^{x21} each independently represent a fluorine atom, or an alkyl group having 1 to 20 carbon atoms in which one or more hydrogen atoms are substituted by a fluorine atom, when a plurality of Rf^{x20}s are present, the plurality of Rf^{x20}s may be different from each other, and when a plurality of Rf^{x21}s are present, the plurality of Rf^{x21}s may be different from each other,
R^{x22} and R^{x23} each independently represent an alkyl group having 1 to 20 carbon atoms, and when a plurality of R^{x22}s and R^{x23}s are present, the plurality of R^{x22}s and R^{x23}s may be different from each other,
X²⁰ and X²¹ each independently represent a hydrolyzable group, and when a plurality of X²⁰s and X²¹s are present, the plurality of X²⁰s and X²¹s may be different from each other,
p20 represents an integer of 1 to 30, p21 represents an integer of 0 to 30, at least one of repeating units bracketed with p20 or p21 is replaced by an amine skeleton -NR¹⁰⁰-, and R¹⁰⁰ in the amine skeleton represents a hydrogen atom or an alkyl group,
p22 and p23 each independently represent an integer of 1 to 3, and
-{C(R^{x20})(R^{X21})}- whose number is p20 and - {C(Rf^{x29})(Rf^{x21})}- whose number is p21 are aligned and bonded in any order, p20 or p21 units may not necessarily be continuous, and both ends are -Si(X²⁰)ₚ₂₂(R^{x22})₃₋ₚ₂₂ and - Si(X²¹)ₚ₂₃(R^{x23})₃₋ₚ₂₃.

7. The method for producing a laminate according to any one of claims 1 to 6, wherein
the organosilicon compound (A) is an organosilicon compound represented by the following formula (a3), and the organosilicon compound (C) is an organosilicon compound represented by the following formula (c2-2): 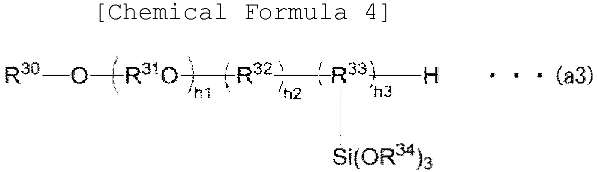
wherein, in formula (a3), R³⁰ is a perfluoroalkyl group having 2 to 6 carbon atoms, R³¹ and R³² each independently represent a perfluoroalkylene group having 2 to 6 carbon atoms, R³³ is a trivalent saturated hydrocarbon group having 2 to 6 carbon atoms, and R³⁴ is an alkyl group having 1 to 3 carbon atoms,
[Chemical Formula 5]
(R^{x25})₃₋ₚ₂₅(X²³)ₚ₂₅Si-C_{w}H_{2w}-Si(X²²)ₚ₂₄(R^{x24})₃₋ₚ₂₄ (c2-2)
wherein, in formula (c2-2), X²² and X²³ each independently represent a hydrolyzable group, when a plurality of X²²s and X²³s are present, the plurality of X²²s and X²³s may be different from each other, R^{x24} and R^{x25} each independently represent an alkyl group having 1 to 20 carbon atoms, when a plurality of R^{x24}s and R^{x25}s are present, the plurality of R^{x24}s and R^{x25}s may be different from each other, at least one methylene group that is a part of -C_{w}H_{2w}- is replaced by an amine skeleton -NR¹⁰⁰-, R¹⁰⁰ represents a hydrogen atom or an alkyl group, w represents an integer of 1 to 30 (excluding the number of the methylene groups replaced by the amine skeleton), and p24 and p25 each independently represent an integer of 1 to 3.

8. The method for producing a laminate according to any one of claims 1 to 7, wherein
after an abrasion resistance test in which a load of 200 g per area of 1.5 cm× 1.5 cm is applied to a surface of the laminate on the water-repellent layer (r) side and rubbing is performed 20,000 times, a characteristic measured on the surface of the laminate on the water-repellent layer (r) side satisfies at least one of the following requirements (1) and (2):
(1) a sliding angle of water is 10° or less; and
(2) a contact angle of water is 110° or more.

9. The method for producing a laminate according to any one of claims 1 to 8, wherein the substrate (s) including the antireflection layer includes the antireflection layer formed on a glass layer or a resin layer.

10. The method for producing a laminate according to any one of claims 1 to 9, wherein the step 2 is a step of forming the water-repellent layer (r) by applying the mixed composition (ca) onto the intermediate layer (c) and curing the mixed composition (ca).

11. The method for producing a laminate according to any one of claims 1 to 10, further comprising step 3 of subjecting the antireflection layer of the substrate (s) including the antireflection layer to a hydrophilization treatment before the step 1, wherein
the step 1 is a step of forming the intermediate layer (c) on the surface of the antireflection layer subjected to the hydrophilization treatment by vapor deposition.

12. A method for producing a spectacle lens, comprising the method for producing a laminate according to any one of claims 1 to 11.
